# EUROPEAN PATENT APPLICATION

(11) **EP 4 756 805 A1**
(43) Date of publication of application: **10.06.2026**
(21) Application number: 25220052.2
(22) Date of filing: 02.12.2025
(51) Int. Cl.: G11C 5/02, G11C 8/08, G11C 8/14, G11C 11/408, G11C 29/52, G06F 11/10

(54) **MEMORY DEVICE WITH PARITY BLOCK ALLOCATION**

(30) Priority: 03.12.2024 KR 20240177960; 10.11.2025 KR 20250168783
(71) Applicant: Samsung Electronics Co., Ltd., Suwon-si, Gyeonggi-do 16677 (KR)
(72) Inventor: SHIN, Hoon, 16677 Suwon-si, Gyeonggi-do (KR); CHOI, Jinyong, 16677 Suwon-si, Gyeonggi-do (KR); YOO, Jaeil, 16677 Suwon-si, Gyeonggi-do (KR); SEOL, Hoseok, 16677 Suwon-si, Gyeonggi-do (KR); KIM, Ki-Heung, 16677 Suwon-si, Gyeonggi-do (KR)
(74) Representative: Kuhnen & Wacker Patent- und Rechtsanwaltsbüro PartG mbB

(57) **Abstract**

A memory device includes a bank array (BA1) including a plurality of memory cells, a row decoder connected to the bank array through a plurality of wordlines, and a column decoder connected to the bank array through a plurality of column select lines. The bank array may include a first region (RG1) comprising a plurality of normal sub-wordline drivers and a second region (RG2) comprising at least one partial sub-wordline driver. One a plurality of column blocks corresponding to the plurality of normal sub-wordline drivers in the first region (RG1) may be allocated as a parity block.

## Description

### BACKGROUND

Memory devices may be used to store data and may be classified into volatile memory devices and nonvolatile memory devices. Volatile memory devices may lose their stored data when their power supplies are interrupted. Among volatile memory devices, a dynamic random access memory (DRAM) may be used in various fields such as mobile systems, servers, graphics devices, or the like.

### SUMMARY

Implementations of the present disclosure provide a memory device satisfying a bounded fault (BF) condition while supporting an error correction code (ECC) operation and/or a metadata mode.

An aspect of the present disclosure provides a memory device that includes a bank array including a plurality of memory cells, a row decoder connected to the bank array through a plurality of wordlines, and a column decoder connected to the bank array through a plurality of column select lines. The bank array may include a first region including a plurality of normal sub-wordline drivers and a second region including at least one partial sub-wordline driver. One of a plurality of column blocks corresponding to the plurality of normal sub-wordline drivers in the first region may be allocated as a parity block.

Another aspect of the present disclosure provides a memory device that includes a bank array each including a plurality of memory cells, a row decoder connected to the bank array through a plurality of wordlines, and a column decoder connected to the bank array through a plurality of column select lines. The bank array may include a first region adjacent to one side surface of the bank array and including column blocks disposed in a direction in which the column decoder is disposed, a second region adjacent to the first region and including column blocks disposed in the direction in which the column decoder is disposed, a third region adjacent to the second region and including column blocks disposed in the direction in which the column decoder is disposed, and a fourth region adjacent to another side surface of the bank array and including at least one column block arranged in the direction in which the column decoder is disposed. Parity data may be output from the second region.

Another aspect of the present disclosure provides a storage device that includes a memory device including a plurality of banks and a memory controller configured to transmit and receive data packets to and from the plurality of banks. The memory device may include a bank array including a plurality of memory cells, a row decoder connected to the bank array through a plurality of wordlines, and a column decoder connected to the bank array through a plurality of column select lines. The bank array includes a first region including a plurality of normal sub-wordline drivers and a second region including at least one partial sub-wordline driver. One of a plurality of column blocks corresponding to the plurality of normal sub-wordline drivers in the first region is allocated as a parity block.

### BRIEF DESCRIPTION OF DRAWINGS

FIG. 1A is a block diagram illustrating an example of a storage device, and FIG. 1B is a conceptual block diagram illustrating an example of a bank array.
FIG. 2 is a block diagram illustrating a configuration of an example of a memory device.
FIG. 3 is a diagram illustrating an example of a bank array.
FIG. 4 is a diagram illustrating an example of a bank structure of an example of a memory device.
FIGS. 5, 6A, 6B, and 7 are diagrams illustrating an example of a memory device operation in a first mode, a second A mode, a second B mode, and a third mode.
FIG. 8 is a diagram illustrating an example of a data packet and an example of a sub-packet.
FIGS. 9A and 9B are diagrams illustrating examples of the BF condition based on a size of a data packet.
FIGS. 10, 11A, 11B, and 11C are diagrams illustrating examples of sub-wordline drivers and column blocks corresponding to each of the sub-wordline drivers.
FIG. 12 is a diagram illustrating a layout relationship of the sub-wordline drivers, sub-wordlines, and column blocks described in FIGS. 10, 11A, 11B, and 11C.
FIG. 13 is a diagram illustrating a comparative example when a column block corresponding to a partial sub-wordline driver is allocated as a parity block.
FIG. 14 is a diagram illustrating an example in which a column block corresponding to a normal sub-wordline driver is allocated as a parity block.
FIG. 15 is a diagram illustrating a comparative example in which a column block corresponding to a bounded sub-wordline driver is allocated as a meta block.
FIG. 16 is a diagram illustrating an example in which a column block corresponding to a non-bounded sub-wordline driver is allocated as a meta block.
FIG. 17 is a block diagram illustrating an example of a storage device.
FIG. 18 is a diagram illustrating an example of a bank array of FIG. 17.
FIG. 19 is a block diagram illustrating an example of a storage device.
FIG. 20 is a diagram illustrating an example of a bank array of FIG. 19.
FIG. 21 is a block diagram illustrating an example of a storage device.
FIG. 22 is a diagram illustrating an example of a bank array of FIG. 21.
FIG. 23 is a block diagram illustrating an example of a storage device.
FIG. 24 is a diagram illustrating an example of a bank array of FIG. 23.

### DETAILED DESCRIPTION

The following description with reference to the accompanying drawings is provided to assist in a comprehensive understanding of various implementations of the present disclosure.

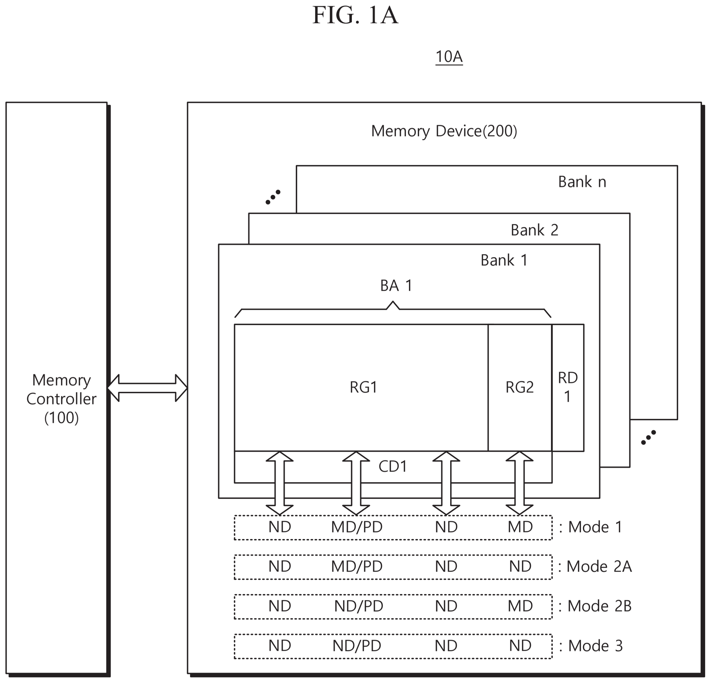

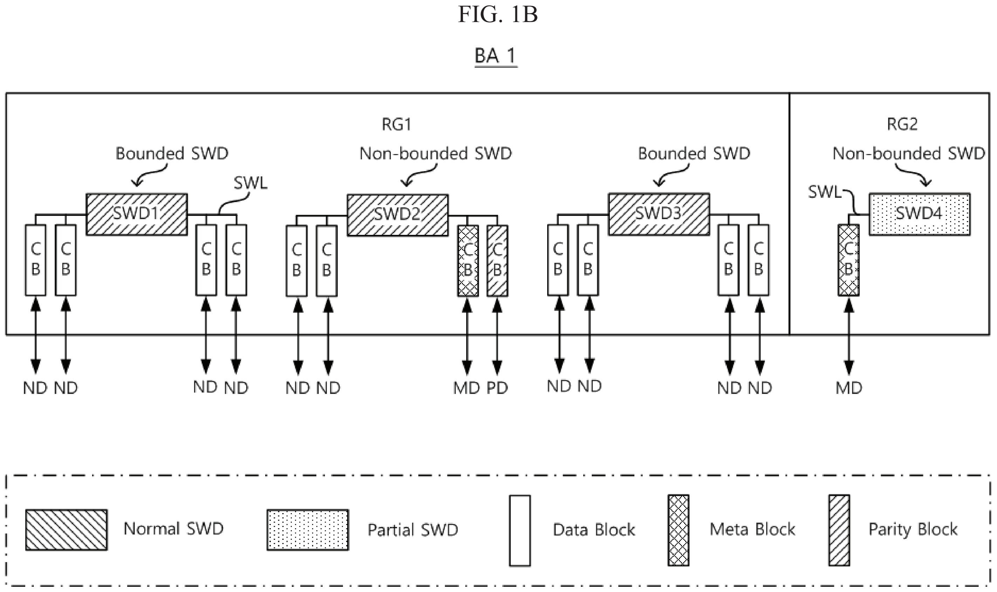

FIG. 1A is a block diagram illustrating a storage device 10A according to some implementations, and FIG. 1B is a conceptual block diagram illustrating an example of a bank array according to some implementations.

The storage device 10A according to some implementations may include a plurality of banks Bank 1 to Bank n, and each bank may include a bank array. Each bank array may include a first region RG1 and a second region RG2. The first region RG1 may mainly refer to a region including column blocks corresponding to a normal sub-wordline driver, and the second region RG2 may mainly refer to a region including column blocks corresponding to a partial sub-wordline driver. For example, the number of column blocks corresponding to the normal sub-wordline driver may be greater than the number of column blocks corresponding to the partial sub-wordline driver.

The storage device 10A according to some implementations may select one of a plurality of normal sub-wordline drivers in the first region RG1 and allocate at least one of the column blocks corresponding to the selected normal sub-wordline driver as a parity block. The parity block may refer to a column block in which parity data for an error correction code operation (hereinafter, referred to as "ECC operation") is stored.

As will be described below, the selected normal sub-wordline driver becomes non-bounded. Accordingly, the number of bounded sub-wordline drivers may be reduced compared to the case in which the column block corresponding to the partial sub-wordline driver is allocated as the parity block. Accordingly, design complexity for satisfying a bounded fault condition (hereinafter, referred to as "BF condition") may be reduced.

The storage device 10A according to some implementations may allocate at least one of the column blocks of a non-bounded sub-wordline driver as a meta block. The meta block is a column block for supporting a metadata mode, and may refer to a column block in which metadata is stored in a meta-on mode and normal data is stored in a meta-off mode.

As will be described below, the number of combinations of data blocks that need to be considered to satisfy the BF condition is reduced, or the data blocks no longer need to be considered. Accordingly, the design complexity for satisfying the BF condition may be reduced compared to the case in which the column block of the bounded sub-wordline driver is allocated as the meta block.

As a result, the storage device 10A according to some implementations may be implemented to satisfy the BF condition while supporting the ECC operation and/or the metadata mode.

Referring to FIG. 1A and FIG. 1B, the storage device 10A according to some implementations may include a memory controller 100 and a memory device 200.

The memory controller 100 may control the memory device 200. For example, the memory controller 100 may control the memory device 200 based on requests from a processor supporting various applications such as a server application, a personal computer (PC) application, or a mobile application. For example, the memory controller 100 may be included in a host including a processor, and may control the memory device 200 based on the requests from the processor.

The memory controller 100 may transmit commands and/or addresses to the memory device 200 to control the memory device 200. In addition, the memory controller 100 may transmit data to the memory device 200 or receive data from the memory device 200.

The memory device 200 may receive data from the memory controller 100 and store the received data. The memory device 200 may read the stored data in response to a request from the memory controller 100 and transmit the read data to the memory controller 100.

In some implementations, the memory device 200 may be a memory device including volatile memory cells. For example, the memory device 200 may be one of various DRAM devices such as a double data rate synchronous dynamic random access memory (DDR SDRAM) device, a DDR2 SDRAM device, a DDR3 SDRAM device, a DDR4 SDRAM device, a DDR5 SDRAM device, a DDR6 SDRAM device, a low power double data rate (LPDDR) SDRAM device, an LPDDR2 SDRAM device, an LPDDR3 SDRAM device, an LPDDR4 SDRAM device, an LPDDR4X SDRAM device, an LPDDR5 SDRAM device, a graphics double data rate synchronous graphics random access memory (GDDR SGRAM) device, a GDDR2 SGRAM device, a GDDR3 SGRAM device, a GDDR4 SGRAM device, a GDDR5 SGRAM device, or a GDDR6 SGRAM device.

In some examples, the memory device 200 may be a stacked memory device in which DRAM dies are stacked, such as a high bandwidth memory (HBM) device, an HBM2 device, an HBM3 device, or an HBM4 device.

In some implementations, the memory device 200 may be included in a memory module such as a dual in-line memory module (DIMM). For example, the memory device 200 may be included in a registered DIMM (RDIMM), a load reduced DIMM (LRDIMM), an unbuffered DIMM (UDIMM), a fully buffered DIMM (FB-DIMM), a small outline DIMM (SO-DIMM). However, this is only an example, and the memory device 200 may be included in another memory module such as a single in-line memory module (SIMM).

In some implementations, the memory device 200 may be an SRAM device, a NAND flash memory device, a NOR flash memory device, an RRAM device, an FRAM device, a PRAM device, a TRAM device, or an MRAM device.

The memory device 200 may include a plurality of banks Bank 1 to Bank n.

Each of the plurality of banks Bank 1 to Bank n may include a bank array, a row decoder, and a column decoder. For example, a first bank Bank 1 may include a first bank array BA1, a first row decoder RD1, and a first column decoder CD1.

A plurality of bank arrays BA1 to BAn may each include memory cells storing data. The row decoder may activate a selected wordline among a plurality of wordlines based on a row address. The column decoder may activate a selected column select line among a plurality of column select lines based on a column address.

For ease of description, it is defined that each bank array includes DRAM cells. However, this is only an example, and each bank array may be implemented to include volatile memory cells other than DRAM cells. In some implementations, each bank array may be implemented to include memory cells of the same type, or implemented to include memory cells of different types.

Each of the plurality of bank arrays BA1 to BAn according to some implementations may include a first region RG1 and a second region RG2.

The first region RG1 may include column blocks corresponding to the normal sub-wordline driver. For example, normal sub-wordline drivers and column blocks corresponding thereto may be disposed in the first region RG1.

For example, as illustrated in FIG. 1B, three normal sub-wordline drivers SWD1, SWD2, and SWD3 and column blocks CB corresponding thereto may be disposed in the first region RG1. However, this is merely an example, and the number of normal sub-wordline drivers disposed in the first region RG1 is not limited thereto. In addition, according to some implementations, the normal sub-wordline drivers in the first region RG1 may be disposed to have a symmetrical structure of even and odd types. A portion of the partial sub-wordline drivers may be disposed in the first region RG1.

The second region RG2 may include column blocks corresponding to a partial sub-wordline driver. For example, partial sub-wordline drivers and column blocks corresponding thereto may be disposed in the second region RG2.

For example, as illustrated in FIG. 1B, a single partial sub-wordline driver SWD4 and a single column block CB corresponding thereto may be disposed in the second region RG2. However, this is merely an example, and the number of partial sub-wordline drivers and the number of column blocks disposed in the second region RG2 are not limited thereto. According to some implementations, two or more partial sub-wordline drivers may be disposed in the second region RG2. In addition, two or three column blocks may correspond to the partial sub-wordline driver.

The sub-wordline driver according to some implementations may be classified into a normal sub-wordline driver and a partial sub-wordline driver based on the number of corresponding column blocks.

In some implementations, the normal sub-wordline driver may be disposed at a middle and/or one side of the bank array. A sub-wordline may be connected to opposite sides of the normal sub-wordline driver. The normal sub-wordline driver may be electrically connected to column blocks through two corresponding sub-wordlines. For example, as illustrated in FIG. 1B, a single sub-wordline SWL may correspond to two column blocks. Each of the normal sub-wordline drivers SWD1, SWD2, and SWD3 may be electrically connected to four column blocks CB.

In some implementations, the partial sub-wordline driver may be disposed at an edge of the bank array. A sub-wordline may be connected to one side or opposite sides of the partial sub-wordline driver. The partial sub-wordline driver may be electrically connected to column blocks through one or two corresponding sub-wordlines.

For example, as illustrated in FIG. 1B, the partial sub-wordline driver may be connected to a single sub-wordline SWL, and the single sub-wordline SWL may correspond to a single column block. The partial sub-wordline driver SWD4 may be electrically connected to the single column block. However, this is merely an example, and implementations are not limited thereto.

For example, the partial sub-wordline driver may be connected to a single sub-wordline SWL, and the single sub-wordline SWL may correspond to two column blocks. The partial sub-wordline driver SWD4 may be electrically connected to two column blocks.

For example, the partial sub-wordline driver may be connected to two sub-wordlines SWL. One of the two sub-wordlines SWL may correspond to two column blocks, and the other sub-wordline SWL may correspond to a single column block. The partial sub-wordline driver SWD4 may be electrically connected to three column blocks.

The sub-wordline driver according to some implementations may be classified into a bounded sub-wordline driver and a non-bounded sub-wordline driver based on whether an error correction code (ECC) error that may occur during the ECC operation should be limited to a predetermined region to satisfy the BF condition.

For ease of description, it is defined that the BF condition is that data affected by a bounded fault is limited to a maximum of four sub-packets. In addition, it is defined that data output from a single data block form a single sub-packet.

In some implementations, when a fault occurs in a first normal sub-wordline driver SWD1 among the normal sub-wordline drivers SWD1, SWD2, and SWD3 disposed in the first region RG1, a failure may also occur in the four column blocks corresponding to the first normal sub-wordline driver SWD1. The four column blocks connected to the first normal sub-wordline driver SWD1 may all be data blocks storing normal data ND. For example, the data output from the four column blocks connected to the first normal sub-wordline driver SWD1 may form four sub-packets.

The correction error should be limited to the four data blocks connected to the first normal sub-wordline driver SWD1 to satisfy the BF condition. For example, the correction error occurring during the ECC operation should not propagate to a column block connected to another sub-wordline driver. As a result, the normal sub-wordline driver having corresponding column blocks all allocated as data blocks may be classified as a bounded sub-wordline driver.

In some implementations, when a fault occurs in a second normal sub-wordline driver SWD2 among the normal sub-wordline drivers SWD1, SWD2, and SWD3 disposed in the first region RG1, a failure may also occur in the four column blocks corresponding to the second normal sub-wordline driver SWD2. However, one of the four column blocks connected to the second normal sub-wordline driver SWD2 is a parity block storing parity data PD. The parity data PD does not form a sub-packet. For example, the parity block is irrelevant to the BF condition, and thus only the three column blocks connected to the second normal sub-wordline driver SWD2 needs to be considered to satisfy the BF condition.

The correction error does not need to be limited to the column blocks connected to the second normal sub-wordline driver SWD2 to satisfy the BF condition. For example, even when the correction error occurring during the ECC operation propagates to a data block connected to another sub-wordline driver, the number of failed sub-packets is four, which means that the BF condition is still satisfied. As a result, the normal sub-wordline driver in which at least one of the corresponding column blocks is allocated as the parity block may be classified as a non-bounded sub-wordline driver.

In some implementations, when a fault occurs in the partial sub-wordline driver SWD4 disposed in the second region RG2, a failure may also occur in the column block corresponding to the partial sub-wordline driver SWD4. Only one column block is connected to the partial sub-wordline driver SWD4, and thus the number of failed data blocks is also one.

Even when the correction error propagates to a data block connected to another sub-wordline driver, the BF condition may still be satisfied. As a result, the partial sub-wordline driver may be classified as a non-bounded sub-wordline driver.

According to some implementations, the storage device 10A may support the ECC operation. An H-matrix must be designed for the ECC operation. For example, the H-matrix must be designed considering bounded sub-wordline drivers. As the number of bounded sub-wordline drivers among the sub-wordline drivers increases, the design complexity of the H-matrix increases. For example, as the number of non-bounded sub-wordline drivers among the sub-wordline drivers increases, the design complexity of the H-matrix be reduced. As described above, the non-bounded sub-wordline driver includes a sub-wordline driver to which the parity block is allocated, among normal sub-wordline drivers, and a partial sub-wordline driver.

The storage device 10A according to some implementations may select one of the plurality of normal sub-wordline drivers in the first region RG1 and allocate at least one of the column blocks corresponding to the selected normal sub-wordline driver as the parity block. Accordingly, the selected normal sub-wordline driver may be a non-bounded sub-wordline driver. Thus, the number of bounded sub-wordline drivers may be reduced compared to the case in which the column block corresponding to the partial sub-wordline driver is allocated as the parity block. As a result, the design complexity of the H-matrix for satisfying the BF condition may be reduced.

Continuing to refer to FIG. 1A and FIG. 1B, the storage device 10A according to some implementations may support a metadata mode. For example, FIGS. 1A and 1B illustrate an implementation in which two meta blocks are provided to support the metadata mode. The metadata mode may include a first mode Mode 1, a second A mode Mode 2A, a second B mode Mode 2B, and a third mode Mode 3.

The first mode Mode 1 may be a mode in which normal data ND and metadata MD corresponding thereto are stored together in the memory device 200 and read together from the memory device 200. The metadata is related to the normal data, and may be data used to improve performance of the memory device 200 or reinforce security of the memory device 200. For example, the metadata may include information on a type, a length, and an attribute of the corresponding normal data, but implementations are not limited thereto.

In the first mode Mode 1, two meta blocks may be both used to store the metadata MD.

For example, referring to FIGS. 1A and 1B, in the first mode Mode 1, a meta block connected to the second normal sub-wordline driver SWD2 in the first region RG1 may store the metadata MD, and a meta block connected to the partial sub-wordline driver SWD4 in the second region RG2 may store the metadata MD. The first mode Mode 1 may be referred to as, for example, a 'meta-on' mode, because the metadata MD is input and output along with the normal data ND.

In the first mode Mode 1, a read operation or a write operation on the normal data ND and the metadata MD corresponding thereto may be performed simultaneously. For example, the normal data ND and the metadata MD corresponding thereto may be output from the data block and the meta block, respectively, through a single read operation. In addition, the normal data ND and the metadata MD corresponding thereto may be stored in the data block and the meta block, respectively, through a single write operation.

The second A mode Mode 2A and the second B mode Mode 2B may be modes in which the normal data ND and the metadata MD corresponding thereto are stored together in the memory device 200 and read together from the memory device 200.

In the second A mode Mode 2A and the second B mode Mode 2B, one meta block may be used to store the metadata MD, and the other meta blocks may be used to store the normal data ND.

For example, referring to FIG. 1A and FIG. 1B, in the second A mode Mode 2A, a meta block connected to the second normal sub-wordline driver SWD2 in the first region RG1 may store the metadata MD, and a meta block connected to the partial sub-wordline driver SWD4 in the second region RG2 may store the normal data ND.

In the second B mode Mode 2B, a meta block connected to the second normal sub-wordline driver SWD2 in the first region RG1 may store the normal data ND, and a meta block connected to the partial sub-wordline driver SWD4 in the second region RG2 may store the metadata MD.

The second A mode Mode 2A and the second B mode Mode 2B may each be referred to as, for example, a 'meta-on' mode or a 'half meta-on' mode because the metadata MD is input and output along with the normal data ND.

In the second A mode Mode 2A and the second B mode Mode 2B, a read operation or a write operation on the normal data ND and the metadata MD corresponding thereto may be performed simultaneously. For example, the normal data ND and the metadata MD corresponding thereto may be output from the data block and the meta block, respectively, through a single read operation. In addition, the normal data ND and the metadata MD corresponding thereto may be stored in the data block and the meta block, respectively, through a single write operation.

The third mode Mode 3 may be a mode in which only the normal data ND is stored in the memory device 200 and read from the memory device 200.

In the third mode Mode 3, the two meta blocks may be both used to store the normal data ND. For example, referring to FIG. 1A and FIG. 1B, in the third mode Mode 3, a meta block connected to the second normal sub-wordline driver SWD2 in the first region RG1 may store the normal data ND, and a meta block connected to the partial sub-wordline driver SWD4 in the second region RG2 may also store the normal data ND. The third mode Mode 3 may be referred to as, for example, a 'meta-off' mode because the metadata MD is not input and output.

In the third mode Mode 3, a read operation or a write operation on the normal data ND stored in the data block and the meta block may be performed simultaneously. For example, the normal data ND stored in the data block and the normal data ND stored in the meta block may be output, respectively, through a single read operation. In addition, the normal data ND may be stored in the data block and the meta block, respectively, through a single write operation.

The storage device 10A according to some implementations may allocate at least one of the column blocks of the non-bounded sub-wordline driver as the meta block. For example, the meta block may be allocated to the non-bounded sub-wordline driver.

For example, referring to FIG. 1A and FIG. 1B, the two meta blocks may be allocated to the non-bounded sub-wordline driver. For example, the meta block may be allocated to the non-bounded second normal sub-wordline driver SWD2 in the first region RG1. In addition, the meta block may be allocated to the non-bounded partial sub-wordline driver SWD4 in the second region RG2.

The meta block allocated to the second normal sub-wordline driver SWD2 in the first region RG1 may be used to store the metadata MD in the first mode Mode 1 and the second A mode Mode 2A, and may be used to store the normal data ND in the second B mode Mode 2B and the third mode Mode 3. In addition, the meta block allocated to the partial sub-wordline driver SWD4 in the second region RG2 may be used to store the metadata MD in the first mode Mode 1 and the second B mode Mode 2B, and may be used to store the normal data ND in the second A mode Mode 2A and the third mode Mode 3.

When the meta block is used to store the normal data ND, the normal data ND stored in the meta block may be data that supplements or replaces other data blocks. For example, the normal data ND of the meta block may be mapped to other data blocks. Accordingly, when the meta block is allocated to the bounded sub-wordline driver, the number of data blocks that should be considered to design the H-matrix satisfying the BF condition increases by the number of data blocks to which the meta block is mapped. This means that the design complexity of the H-matrix may increase.

In contrast, the storage device 10A according to some implementations may allocate at least one of the column blocks of the non-bounded sub-wordline driver as a meta block. Accordingly, the number of combinations of data blocks that should be considered to satisfy the BF condition may be reduced or does not need to be considered. As a result, the design complexity for satisfying the BF condition may be reduced compared to the case in which the column block of the bounded sub-wordline driver is allocated as the meta block.

As discussed above, the storage device 10A according to some implementations may support the ECC operation and may allocate at least one of the column blocks corresponding to the normal sub-wordline driver as a parity block. Accordingly, the design complexity for satisfying the BF condition may be reduced. In addition, the storage device 10A according to some implementations supports the metadata mode and may allocate at least one of the column blocks of the non-bounded sub-wordline driver as a meta block. As a result, the design complexity for satisfying the BF condition may be reduced.

In FIGS. 1A and 1B, for ease of description, at least one of the column blocks corresponding to the normal sub-wordline driver is allocated as the parity block, and one of the column blocks of the non-bounded sub-wordline driver created by allocating the parity block is allocated as the meta block. However, this is merely an example, and implementations are not limited thereto. For example, the implementation in which the design complexity of the H-matrix is reduced by allocating at least one of the column blocks corresponding to the normal sub-wordline driver as the parity block and the implementation in which the design complexity of the H-matrix is reduced by allocating at least one of the column blocks of the non-bounded sub-wordline driver as the meta block may be implemented independently.

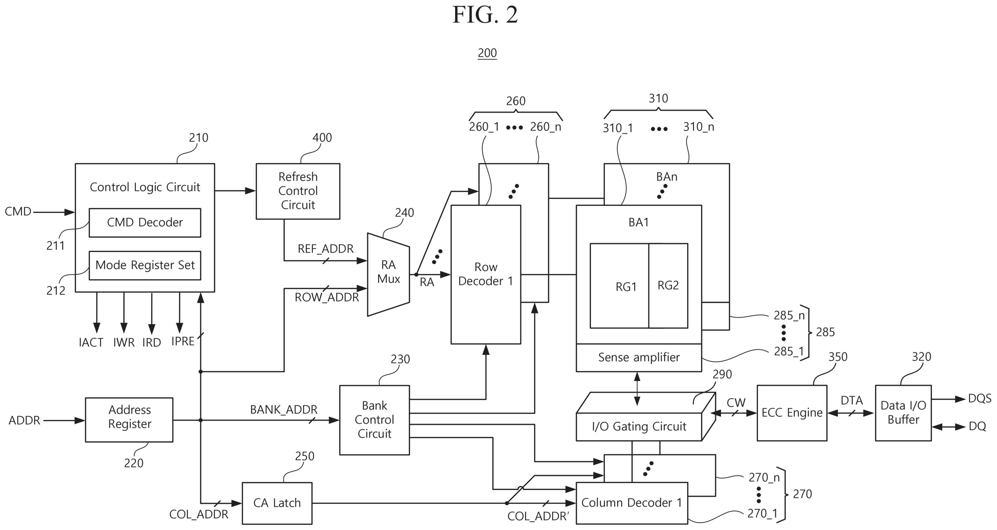

FIG. 2 is a block diagram illustrating a configuration of a memory device 200 according to some implementations. The memory device 200 of FIG. 2 may correspond to the memory device 200 of FIG. 1A.

Referring to FIG. 2, the memory device 200 may include a control logic circuit 210, an address register 220, a bank control circuit 230, a refresh control circuit 400, a row address multiplexer 240, a column address latch 250, a row decoder group 260, a column decoder group 270, a memory cell array 310, a sense amplifier unit 285, an input/output gating circuit 290, an ECC engine 350, and a data input/output buffer 320.

The memory cell array 310 may include a plurality of bank arrays 310_1 to 310_n. Each of the plurality of bank arrays 310_1 to 310_n may include a plurality of memory cells. For example, each of the plurality of memory cells may be formed at an intersection of a corresponding wordline and a corresponding bitline.

The row decoder group 260 may include a plurality of row decoders 260_1 to 260_n. Each of the plurality of row decoders 260_1 to 260_n may be connected to a corresponding bank array among the plurality of bank arrays 310_1 to 310_n.

The sense amplifier unit 285 may include a plurality of sense amplifiers 285_1 to 285_n. Each of the plurality of sense amplifiers 285_1 to 285_n may be connected to a corresponding bank array among the plurality of bank arrays 310_1 to 310_n.

The column decoder group 270 may include a plurality of column decoders 270_1 to 270_n. Each of the plurality of column decoders 270_1 to 270_n may be connected to a corresponding bank array of the plurality of bank arrays 310_1 to 310_n through column select lines.

According to some implementations, each of the plurality of bank arrays 310_1 to 310_n may include the first region RG1 and the second region RG2. In the first region RG1, normal sub-wordline drivers and column blocks corresponding thereto may be mainly disposed. In the second region RG2, partial sub-wordline drivers and column blocks corresponding thereto may be mainly disposed.

According to some implementations, one of the plurality of normal sub-wordline drivers disposed in the first region RG1 is selected, and a parity block may be allocated to at least one of the column blocks corresponding to the selected normal sub-wordline driver. The selected normal sub-wordline driver may be non-bounded. Accordingly, the design complexity for satisfying the BF condition may be reduced.

According to some implementations, at least one of the column blocks of the non-bounded sub-wordline driver may be allocated as the meta block. For example, the column block of the normal sub-wordline driver to which the parity block is allocated, among the plurality of normal sub-wordline drivers in the first region RG1, and/or the column block of the partial sub-wordline driver of the second region RG2 may be allocated as the meta block. Accordingly, the design complexity for satisfying the BF condition may be reduced.

The address register 220 may receive an address ADDR including a bank address BANK_ADDR, a row address ROW_ADDR, and a column address COL_ADDR from the memory controller 100 (refer to FIG. 1A). The address register 220 may provide the received bank address BANK_ADDR to the bank control circuit 230, may provide the received row address ROW_ADDR to the row address multiplexer 240, and may provide the received column address COL_ADDR to the column address latch 250.

The bank control circuit 230 may generate bank control signals in response to the bank address BANK_ADDR. As an example, a row decoder corresponding to the bank address BANK_ADDR among the row decoders 260_1 to 260_n may be activated in response to the bank control signals. A column decoder corresponding to the bank address BANK_ADDR among the column decoders 270_1 to 270_n may be activated in response to the bank control signals.

The row address multiplexer 240 may receive the row address ROW_ADDR from the address register 220 and may receive a refresh row address REF_ADDR from the refresh control circuit 400. The row address multiplexer 240 may selectively output the row address ROW_ADDR or the refresh row address REF_ADDR as a row address RA. The row address RA output from the row address multiplexer 240 may be applied to each of the row decoders 260_1 to 260_n.

The refresh control circuit 400 may sequentially increase or decrease the refresh row address REF_ADDR in a normal refresh mode in response to refresh signals from the control logic circuit 210.

The refresh control circuit 400 may receive a hammer address HADDR in a hammer refresh mode. The refresh control circuit 400 may output an address of adjacent memory cell rows adjacent to an aggressor memory cell row as the refresh row address REF_ADDR based on the hammer address HADDR.

A row decoder selected by the bank control circuit 230, among the plurality of row decoders 260_1 to 260_n, may activate a wordline corresponding to the row address RA output from the row address multiplexer 240. For example, the selected row decoder may apply a wordline driving voltage to the wordline corresponding to the row address.

The column address latch 250 may receive the column address COL_ADDR from the address register 220 and may temporarily store the received column address COL_ADDR. In addition, for example, in a burst mode, the column address latch 250 may gradually increase the received column address COL_ADDR. The column address latch 250 may apply a column address COL_ADDR' obtained by temporarily storing or gradually increasing the column address COL_ADDR to each of the column decoders 270_1 to 270_n.

The column decoder activated by the bank control circuit 230, among the plurality of column decoders 270_1 to 270_n, may activate the sense amplifier corresponding to the bank address BANK_ADDR and the column address COL_ADDR through the I/O gating circuit 290.

The I/O gating circuit 290 may include circuits to perform gating input and output data. In addition, the I/O gating circuit 290 may include data latches to store code words output from the bank arrays 310_1 to 310_n and write drivers to write data in the bank arrays 310_1 to 310_n.

In some implementations, a code word CW read out from the selected bank array among the bank arrays 310_1 to 310_n during the read operation may be sensed by the sense amplifier corresponding to the selected bank array and may be stored in the data latches of the I/O gating circuit 290. In addition, the code word CW stored in the data latches may be ECC decoded by the ECC engine 350 and may be provided to the data I/O buffer 320 as data DTA. The data I/O buffer 320 may generate the data signal DQ based on the data DTA and may provide the data signal DQ together with the data strobe signal DQS to the memory controller 100.

In some implementations, during the write operation, data DTA to be written in the selected bank array among the bank arrays 310_1 to 310_n may be received as the data signal DQ by the data I/O buffer 320. The data I/O buffer 320 may convert the data signal DQ into the data DTA and may provide the data DTA to the ECC engine 350. The ECC engine 350 may generate parity bits or parity data based on the data DTA and may provide the code word CW including the data DTA and the parity bits to the I/O gating circuit 290. The I/O gating circuit 290 may write the code word CW in the selected bank array.

The data I/O buffer 320 may convert the data signal DQ into the data DTA during the write operation and may provide the data DTA to the ECC engine 350. The data I/O buffer 320 may convert the data DTA provided from the ECC engine 350 into the data signal DQ during the read operation.

The ECC engine 350 may perform an ECC encoding operation on the data DTA during the write operation. The ECC engine 350 may perform an ECC decoding operation on the code word CW during the read operation.

The control logic circuit 210 may control an operation of the memory device 200. As an example, the control logic circuit 210 may generate the control signals to allow the memory device 200 to perform the write operation, the read operation, the normal refresh operation, and the hammer refresh operation. The control logic circuit 210 may include a command decoder 211 that decodes a command CMD provided from the memory controller 100 and a mode register set (MRS) 212 that sets an operation mode of the memory device 200.

The command decoder 211 may decode the command CMD to generate internal command signals such as an internal active signal IACT, an internal precharge signal IPRE, an internal read signal IRD, an internal write signal IWR, etc. In addition, the command decoder 211 may decode a chip select signal and command/address signals to generate control signals corresponding to the command CMD.

The mode register set 212 may set the operation mode of the memory device 200. According to some implementations, the mode register set 212 may include a mode register to set the operation mode of the memory device 200 to the first mode Mode 1, the second A mode Mode 2A, the second B mode Mode 2B, or the third mode Mode 3. For example, when a first value is set in the mode register, the memory device 200 may operate in the first mode Mode 1. When a second value is set in the mode register, the memory device 200 may operate in the second A mode Mode 2A. Similarly, when a third value or a fourth value is set in the mode register, the memory device 200 may operate in the second B mode Mode 2B or the third mode Mode 3.

According to some implementations, the first region RG1 and the second region RG2 may be commonly connected to a plurality of wordlines. Therefore, when a single wordline corresponding to the row address among the plurality of wordlines is activated, a region corresponding to the activated wordline may be activated together in the first region RG1 and the second region RG2. When the column address is applied, the column select lines of the first region RG1 corresponding to the applied column address and the column select lines of the second region RG2 corresponding to the applied column address may be activated simultaneously.

Accordingly, when the memory device 200 operates in the first mode Mode 1, the second A mode Mode 2A, and the second B mode Mode 2B, the normal data, the metadata, and the parity data may be input together or output together. In addition, when the memory device 200 operates in the third mode Mode 3, the normal data and the parity data may be input together or output together.

As described above, the memory device 200 according to some implementations may support the ECC operation and may allocate at least one of the column blocks corresponding to the normal sub-wordline driver as a parity block. Accordingly, the design complexity for satisfying the BF condition may be reduced. The memory device 200 according to some implementations may support the metadata mode and may allocate at least one of the column blocks of the non-bounded sub-wordline driver as a meta block. Accordingly, the design complexity for satisfying the BF condition may be reduced.

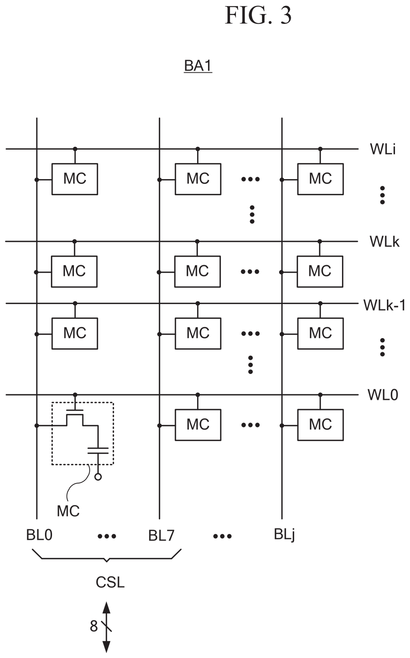

FIG. 3 is a diagram illustrating an example of a bank array according to some implementations. The bank array BA1 of FIG. 3 may correspond to the bank array BA1 of FIGS. 1A and 1B and FIG. 2, but implementations are not limited thereto.

Referring to FIG. 3, the first bank array BA1 may include a plurality of wordlines WL0 to WLi, a plurality of bitlines BL0 to BLj, and a plurality of memory cells MC. The plurality of memory cells MC may be disposed at the intersection of the wordlines WL0 to WLi and the bitlines BL0 to BLj.

In some implementations, each memory cell MC may be a DRAM cell. For example, each memory cell MC may include a cell transistor, connected to a wordline and a bitline, and a cell capacitor connected to the cell transistor.

A single column select line CSL may be electrically connected to a plurality of bitlines. For example, the single column select line CSL may be electrically connected to eight bitlines BL0 to BL7. In some examples, 8 bits of data may be read from or written in memory cells MCs through a single wordline and a single column select line CSL. However, this is merely an example, and the one column select line CSL may also be implemented to be electrically connected to a various number of bitlines other than 8.

In some implementations, the wordlines extending in a row direction may be referred to as a row of the bank array BA1. In addition, the column select lines CSL extending in a column direction may be referred to as a column of the bank array BA1.

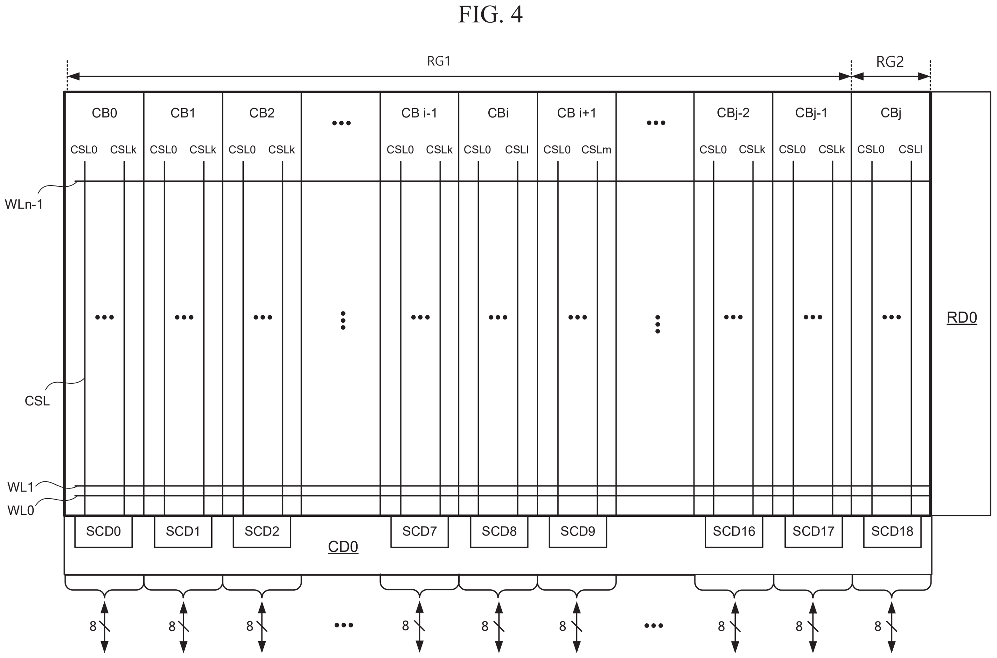

FIG. 4 is a diagram illustrating a bank structure of a memory device according to some implementations. A bank of FIG. 4 may be, for example, one of the banks included in the memory device 200 of FIG. 1A or FIG. 2, but implementations are not limited thereto. For ease of description, similarly to FIG. 3, it is defined that a single column select line CSL corresponds to eight bitlines.

Referring to FIG. 4, the bank may include a bank array BA, a row decoder RD corresponding to the bank array BA, and a column decoder CD corresponding to the bank array BA. In FIG. 4, WL may denote a wordline and CSL may denote a column select line.

The bank array BA may include a plurality of column blocks CB0 to CBj. At least one of the plurality of column blocks CB0 to CBj may be allocated as a parity block. At least one of the plurality of column blocks CB0 to CBj may be allocated as a meta block. Among the plurality of column blocks CB0 to CBj, column blocks excluding the meta block and the parity block may be allocated as data blocks.

It is defined that first to (j-1)-th column blocks CB0 to CBj-1 correspond to the above-described first region RG1 and j-th column block CBj corresponds to the above-described second region RG2. In addition, it is defined that two meta blocks and one parity block are allocated.

At least one column block connected to a normal sub-wordline driver, among the first to (j-1)-th column blocks CB0 to CBj-1 in the first region RG1, may be allocated as a parity block. For example, an (i+1)-th column block CBi+1 may be allocated as the parity block.

In addition, a column block adjacent to the (i+1)-th column block CBi+1 allocated as the parity block, among the first to (j-1)-th column blocks CB0 to CBj-1 in the first region RG1, may be allocated as a meta block. For example, the i-th column block CBi corresponding to the same sub-wordline driver as the (i+1)-th column block CBi+1 may be allocated as the meta block.

In addition, the j-th column block CBj in the second region RG2 may be allocated as a meta block. For example, a column block connected to the partial sub-wordline driver may be allocated as the meta block.

In addition, column blocks excluding the column blocks CBi, CBi+1, and CBj allocated as the parity block and the meta block may be allocated as data blocks.

In some implementations, the number of column select lines CSLO to CSLI of the column blocks CBi, CBj allocated as the meta block may be different from the number of column select lines CSLO to CSLk of the column block allocated as the data block. For example, the number of column select lines CSLO to CSLI of the column blocks CBi, CBj allocated as the meta block may be 64 (for example, l=63), and the number of column select lines CSLO to CSLk of the column block allocated as the data block may be 60 (for example, k=59). However, this is merely an example, and implementations are not limited thereto. According to some implementations, the number of column select lines of the column block allocated as the meta block may be the same as the number of column select lines of the column block allocated as the data block.

In addition, in some implementations, the number of column select lines CSLO to CSLm of the column block CBi+1 allocated as the parity block may be different from the number of column select lines CSLO to CSLk of the column block allocated as the data block. For example, the number of column select lines CSLO to CSLm of the column block CBi+1 allocated as the parity block may be 64 (for example, m=63), and the number of column select lines CSLO to CSLk of the column block allocated as the data block may be 60 (for example, k=59). However, this is merely an example, and implementations are not limited thereto. According to some implementations, the number of column select lines of the column block allocated as the parity block may be the same as the number of column select lines of the column block allocated as the data block.

The row decoder RD may activate a wordline corresponding to the applied row address, and the column decoder CD may activate a column select line corresponding to the applied column address. According to some implementations, the column decoder CD may include j+1 sub-column decoders SCD0 to SCDj, respectively corresponding to j+1 column blocks CB0 to CBj, and an operation of each column block may be controlled by a corresponding sub-column decoder. However, implementations are not limited thereto.

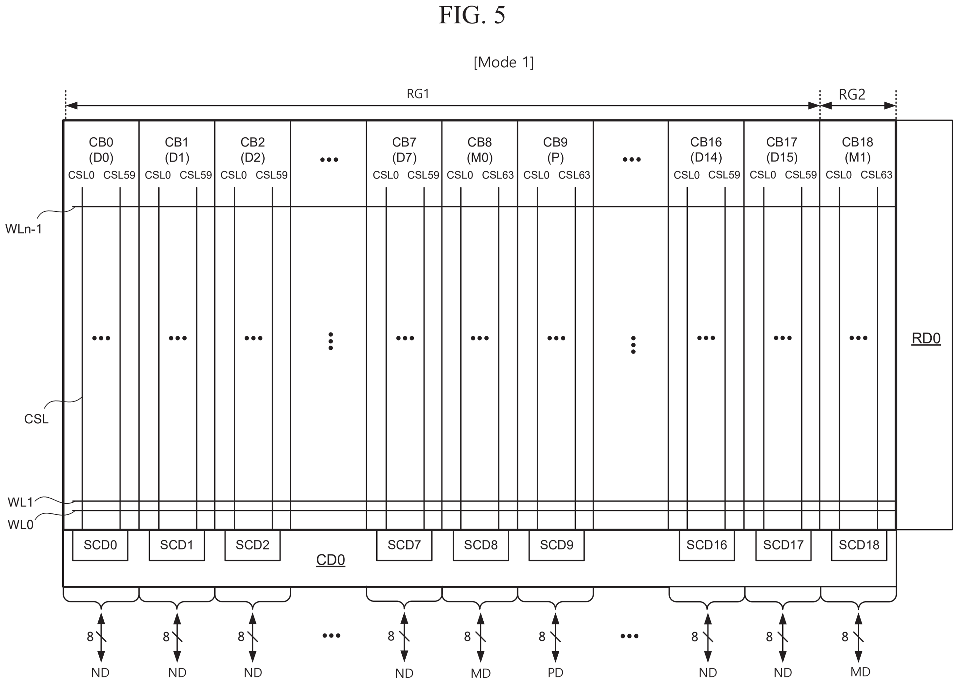

According to some implementations, the bank may support one of the above-described first mode Mode 1, second A mode Mode 2A, second B mode Mode 2B, and third mode Mode 3. This will be described in more detail in FIGS. 5 to 7 below.

FIGS. 5 to 7 are diagrams illustrating an example in which the memory device 200 according to some implementations operates in the first mode Mode 1, the second A mode Mode 2A, the second B mode Mode 2B, and the third mode Mode 3. For ease of description, FIGS. 5 to 7 illustrates an example in which the bank includes 19 column blocks, a column block allocated as a data block includes 60 column select lines, and a column block allocated as a meta block or the parity block includes 64 column select lines. In addition, FIGS. 5 to 7 illustrate an example in which two column blocks CB8 and CB18, among the 19 column blocks CB0 to CB18, are allocated as meta blocks, one column block CB9 is allocated as a parity block, and the remaining 16 column blocks are allocated as data blocks.

Referring to FIG. 5, in the first mode Mode 1, the two meta blocks M0 and M1 may be both used to store metadata MD. The bank may operate based on 60 column addresses, respectively corresponding to 60 column select lines.

For example, when a column address corresponding to one column select line (for example, CSLO) is applied in a state where a first wordline WL0 is activated, the column decoder CD may activate the column select line CSLO in each of the 19 column blocks CB0 to CB18.

Each activated column select line CSLO corresponds to 8 bitlines. Therefore, the column block CB9 allocated as a parity block P, among the column blocks CB0 to CB17 of the first region RG1, may input or output 8 bits of parity data PD, the column block CB8 allocated as the 0th meta block M0 may input or output 8 bits of metadata MD, and each of the remaining column blocks allocated as data blocks D0 to D15 may input or output 8 bits of normal data ND. In addition, the column block CB18 allocated as a first meta block M1 of the second region RG2 may input or output 8 bits of metadata. This may be equally applied to the remaining column addresses CSL1 to CSL59.

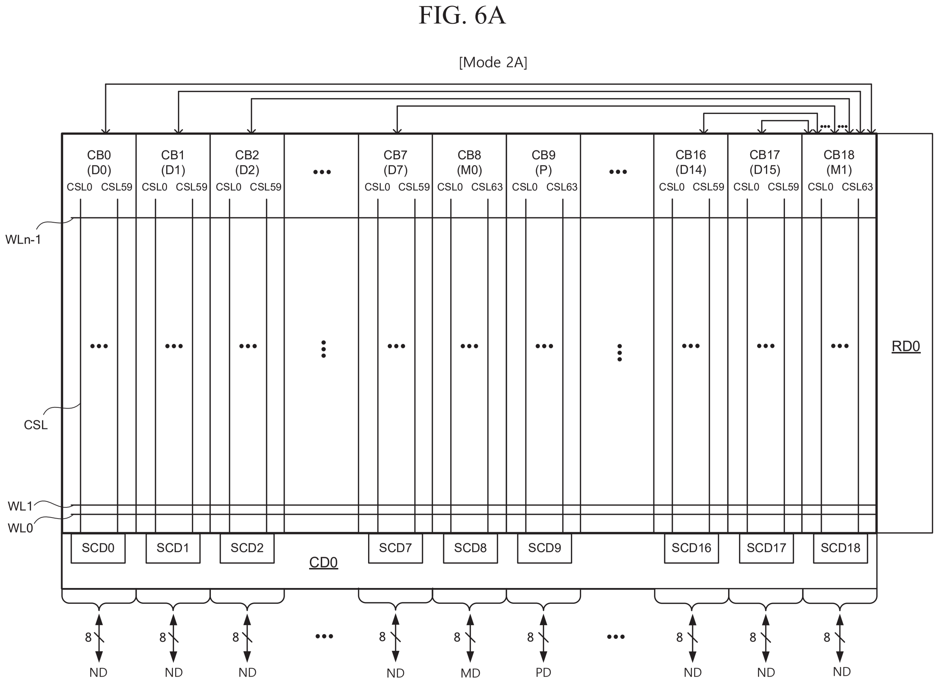

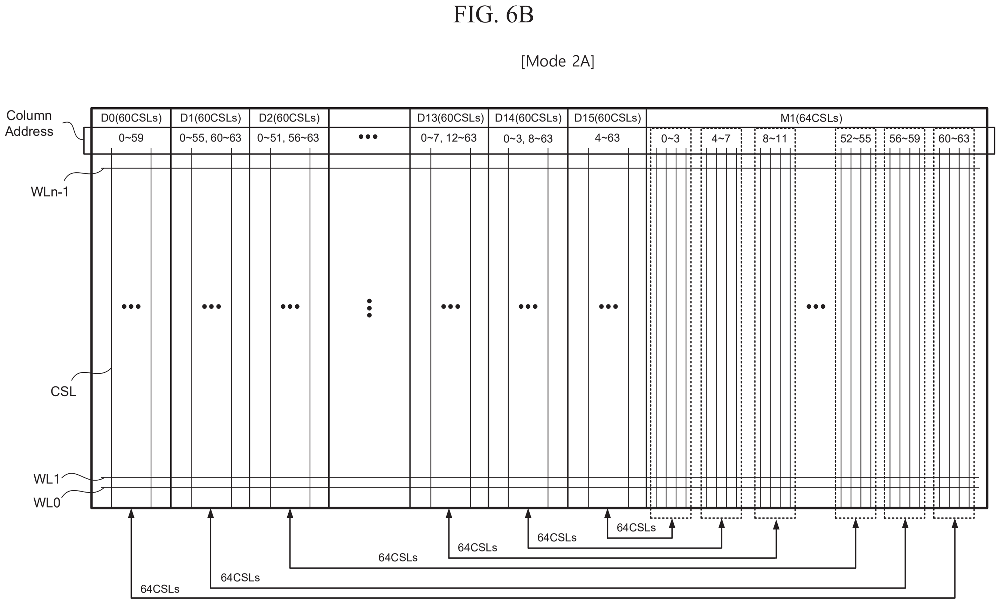

Referring to FIG. 6A and FIG. 6B, in the second A mode Mode 2A, among the two meta blocks M0 and M1, the 0th meta block M0 may be used to store the metadata MD and the first meta block M1 may be used to store the normal data ND. The bank may operate based on 64 column addresses, respectively corresponding to 64 column select lines.

In some implementations, the normal data ND stored in the first meta block M1 may be data for the 0th to 15th data blocks D0 to D15. For example, the column select lines of the first meta block M1 may be mapped to the 0th to 15th data blocks D0 to D15 in units of 4, respectively. The 60 column select lines included in each data block and the 4 column select lines included in the first meta block M1 may form column addresses for a single data block.

For example, the 60 column select lines included in the 0th data block D0 and the four column select lines included in the first meta block M1 may form a column address for the 0th data block D0. The column addresses of the 60 column select lines included in the 0th data block D0 may be set to '0 to 59,' and the column addresses of the 4 column select lines included in the first meta block M1 may be set to '60 to 63.'

In addition, for example, the 60 column select lines included in the first data block D1 and the 4 column select lines included in the first meta block M1 may form a column address for the first data block D1. The column addresses of the 60 column select lines included in the first data block D1 may be set to '0 to 55 and 60 to 63,' and the column addresses of the 4 column select lines included in the first meta block M1 may be set to '56 to 59.'

Similarly, column addresses for the remaining data blocks D2 to D15 may be configured using the column select lines of each data block and the corresponding first meta block M1.

In the second B mode Mode 2B, among the two meta blocks M0 and M1, the 0th meta block M0 may be used to store the normal data ND and the first meta block M1 may be used to store the metadata MD. The normal data ND stored in the 0th meta block M0 may be data for the 0th to 15th data blocks D0 to D15. The operation of the second B mode Mode 2B is similar to the operation of the second A mode Mode 2A, and thus a detailed description thereof will be omitted.

According to the above-described mapping relationship, in the second A mode Mode 2A and the second B mode Mode 2B, the bank may operate based on 64 column addresses.

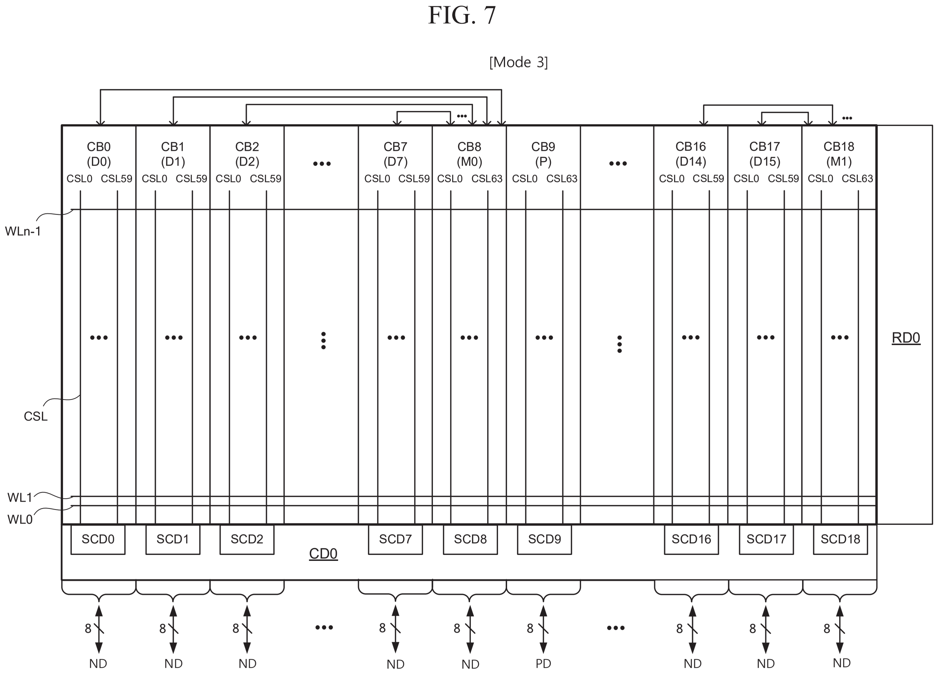

Referring to FIG. 7, in the third mode Mode 3, the two meta blocks M0 and M1 may be both used to store the normal data ND.

In some implementations, the normal data ND stored in the 0th meta block M0 may be data for the 0th to 7th data blocks D0 to D7. For example, the column select lines of the 0th meta block M0 may be mapped to the 0th to 7th data blocks D0 to D7 in units of 8, respectively. The 60 column select lines included in each data block and the 8 column select lines included in the 0th meta block M0 may form column addresses for a single data block.

In some implementations, the normal data ND stored in the first meta block M1 may be data for the 8th to 15th data blocks D8 to D15. For example, the column select lines of the first meta block M1 may be mapped to the 8th to 15th data blocks D8 to D15 in units of 8, respectively. The 60 column select lines included in each data block and the 8 column select lines included in the first meta block M1 may form column addresses for a single data block.

According to the above-described mapping relationship, in the third mode Mode 3, the bank may operate based on a maximum of 68 column addresses.

As described in FIGS. 5 to 7, the storage device according to some implementations may support various modes by supporting the ECC operation and the metadata mode. In each mode, the storage device according to some implementations may read normal data, metadata, and/or parity data together from a bank array through a single read operation, or store the normal data, the metadata, and/or the parity data together in the bank array through a single write operation.

In addition, as will described below, the storage device according to some implementations may reduce the design complexity of an H-matrix by allocating at least one of the column blocks corresponding to the normal sub-wordline driver as a parity block or by allocating at least one of the column blocks of the non-bounded sub-wordline driver as a meta block. As a result, the memory device may be efficiently implemented.

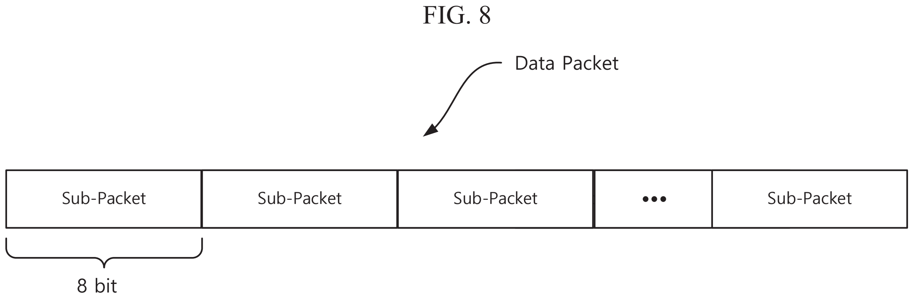

FIG. 8 is a diagram illustrating a structure of a data packet and a sub-packet according to some implementations.

Referring to FIG. 8, a single data packet may include a plurality of sub-packets. The data packet may refer to a unit of data transmitted from the memory device 200 (see FIG. 1) to the memory controller 100 (see FIG. 1) or received by the memory device 200 from the memory controller 100.

In some implementations, a size of the sub-packet may be the same as a size of data input or output through a single column select line. For example, when a single column select line corresponds to 8 bitlines as illustrated in FIGS. 5 to 7, a unit of data input or output to each data block may be 8 bits and a unit of the sub-packet may also be 8 bits.

The sub-packet may be data received from the memory controller 100 or data transmitted to the memory controller 100. Therefore, on-die ECC parity data that is not transmitted to the memory controller 100 may not form a sub-packet.

In some implementations, the sub-packet may include normal data. For example, in the above-described first mode Mode 1, the normal data output from each data block may form a single sub-packet. Alternatively, in the above-described second A mode Mode 2A, second B mode Mode 2B, or third mode Mode 3, the normal data output from each data block and the meta block may form a single sub-packet.

Alternatively, in some implementations, the sub-packet may include normal data and metadata. For example, when the metadata is data that should be transmitted to the memory controller 100, the metadata may also form a sub-packet.

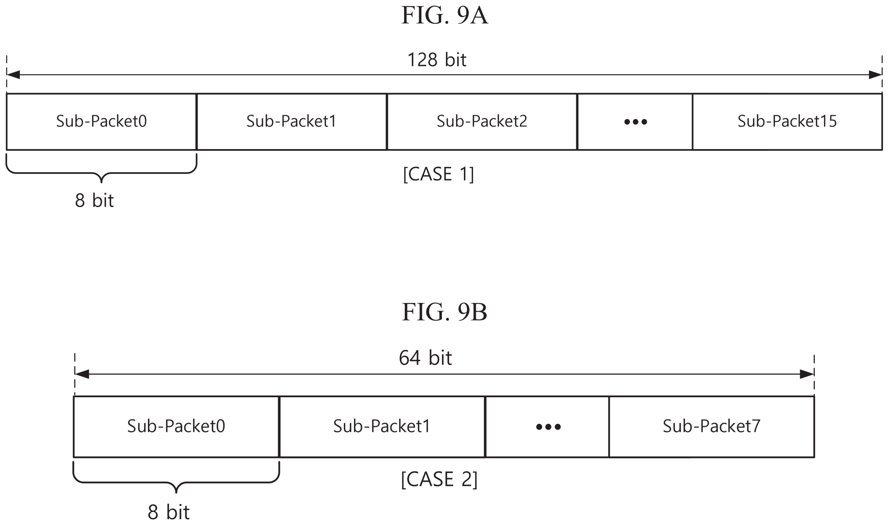

FIGS. 9A and 9B are diagrams illustrating examples of the BF condition according to some implementations.

Referring to FIG. 9A, a data packet may be 128 bits. For example, 16 sub-packets of 8 bits may form a single data packet.

BF condition may be that data affected by a bounded fault is limited to a maximum of 4 sub-packets. For example, when 128 bits of data are output and fetched through one read operation as described in FIGS. 5 to 7, the data affected by the bounded fault may be limited to a maximum of 4 sub-packets.

Alternatively, referring to FIG. 9B, the data packet may be 64 bits. For example, 8 sub-packets of 8 bits may form a single data packet.

A BF condition may be that data affected by a bounded fault is limited to a maximum of 3 sub-packets.

The storage device according to some implementations may be designed to satisfy the BF condition even when a fault occurs in the sub-wordline driver.

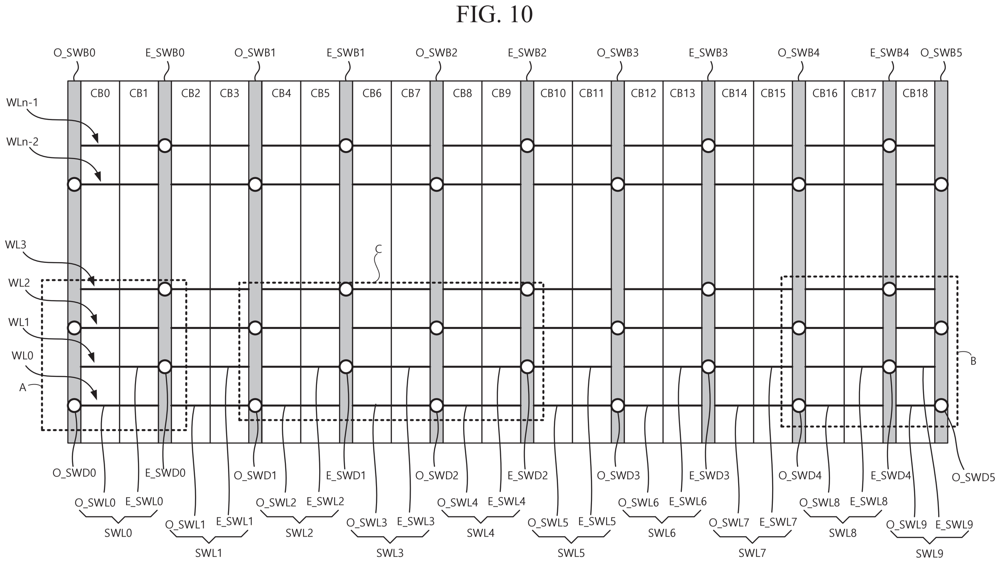

For example, the storage device according to some implementations may satisfy the BF condition while reducing the design complexity of the H-matrix by allocating at least one of the column blocks corresponding to the normal sub-wordline driver as the parity block. This will be described in more detail with reference to FIGS. 10 to 14 below.

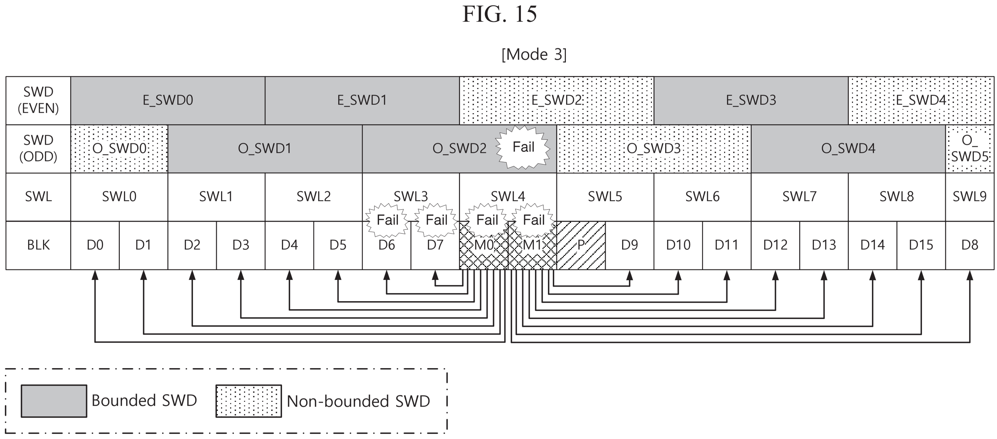

Alternatively, the storage device according to some implementations may satisfy the BF condition while reducing the design complexity of the H-matrix by allocating at least one of the column blocks of the non-bounded sub-wordline driver as the meta block. This will be described in more detail with reference to FIGS. 15 to 18 below.

Hereinafter, for ease of description, it is defined that the BF condition is that data affected by a bounded fault is limited to a maximum of 4 sub-packets.

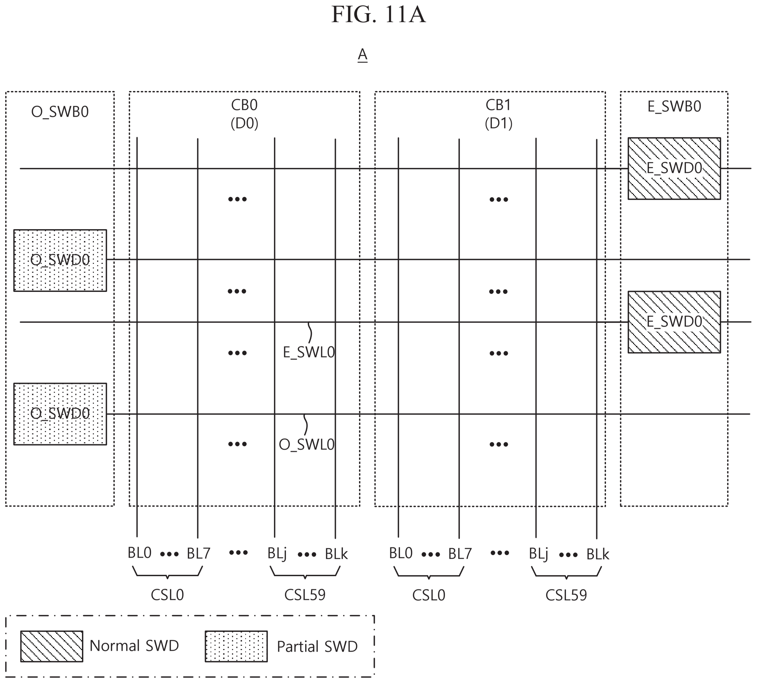

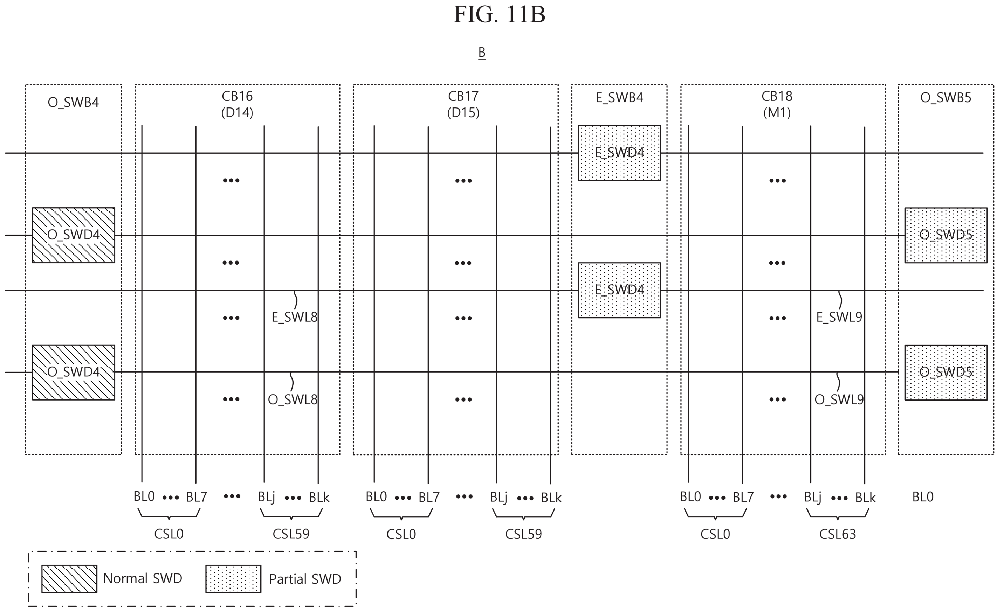

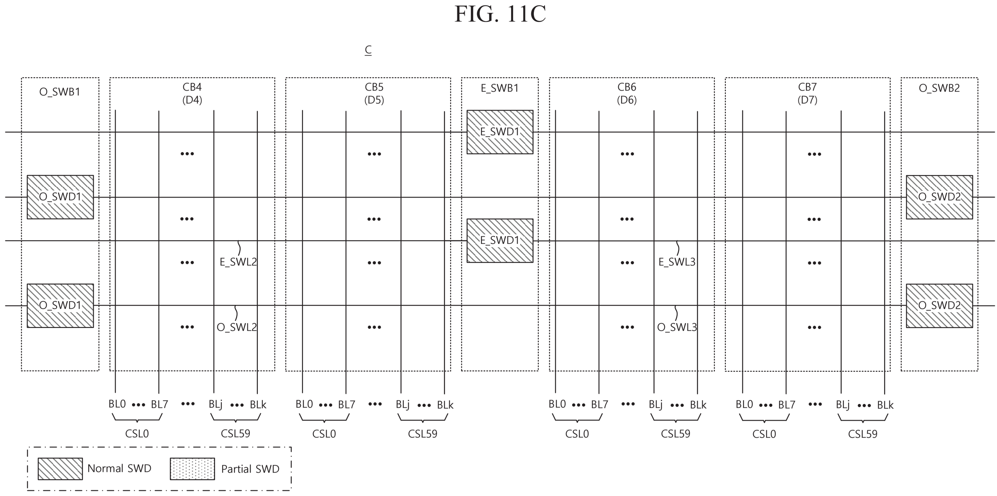

FIGS. 10, 11A, 11B, and 11C are diagrams illustrating sub-wordline drivers and column blocks corresponding to each sub-wordline driver according to some implementations. For example, FIG. 10 illustrates a structure of a bank array of the memory device according to some implementations. FIG. 11A illustrates a sub-wordline driver disposed at the left edge of the bank array and column blocks corresponding thereto. FIG. 11B illustrates a sub-wordline driver disposed at the right edge of the bank array and column blocks corresponding thereto. FIG. 11C illustrates a sub-wordline driver disposed in the middle of the bank array and column blocks corresponding thereto.

For example, the bank array of FIGS. 10, 11A, 11B, and 11C may be one of the bank arrays of the banks included in the memory device of FIGS. 1A, 1B, 2-5, 6A, 6B, and 7, but implementations are not limited thereto. For ease of description, similarly to FIGS. 5 to 7, it is defined that the bank array includes 19 column blocks CB0 to CB18.

Referring to FIG. 10, the bank array may include a plurality of column blocks CB0 to CB18 and a plurality of sub-wordline blocks O_SWB0 to O_SWB5 and E_SWB0 to E_SWB4 disposed between the plurality of column blocks CB0 to CB18.

The plurality of column blocks CB0 to CB18 may each be allocated as one of a data block, a parity block, or a meta block. The plurality of column blocks CB0 to CB18 may correspond to the column blocks CB0 to CB18 described in FIGS. 5 to 7.

The plurality of sub-wordline blocks O_SWB0 to O_SWB5 and E_SWB0 to E_SWB4 may be disposed between the plurality of column blocks CB0 to CB18. Each of the plurality of sub-wordline blocks O_SWB0 to 0_SWB5 and E_SWB0 to E_SWB4 may include at least one sub-wordline driver, and each sub-wordline driver may drive a corresponding sub-wordline.

The plurality of sub-wordline blocks O_SWB0 to O_SWB5 and E_SWB0 to E_SWB4 may be classified into odd sub-wordline blocks O_SWB0 to 0_SWB5 and even sub-wordline blocks E_SWB0 to E_SWB4.

The odd sub-wordline blocks O_SWB0 to O_SWB5 and the even sub-wordline blocks E_SWB0 to E_SWB4 may be alternately disposed.

For example, a 0th odd sub-wordline block O_SWB0 may be disposed at the left edge of the bank array, and a 0th even sub-wordline block E_SWB0 may be disposed between a first column block CB1 and a second column block CB2. In addition, a first odd sub-wordline block O_SWB1 may be disposed between a third column block CB3 and a fourth column block CB4, and a first even sub-wordline block E_SWB1 may be disposed between a fifth column block CB5 and a sixth column block CB6. Similarly, second to fifth odd sub-wordline blocks O_SWB2 to O_SWB5 and second to fourth even sub-wordline blocks E_SWB2 to E_SWB4 may be alternately disposed.

Each of the odd sub-wordline blocks O_SWB0 to O_SWB5 may include a plurality of odd sub-wordline drivers.

For example, the 0th odd sub-wordline block O_SWB0 may include a plurality of 0th odd sub-wordline drivers O_SWD0. The first odd sub-wordline block O_SWB1 may include a plurality of first odd sub-wordline drivers 0_SWD1. Similarly, the second to fifth odd sub-wordline blocks 0_SWB2 to 0_SWB5 may each include a plurality of odd sub-wordline drivers.

The odd sub-wordline block disposed at the edge, among the odd sub-wordline blocks O_SWB0 to O_SWB5, may include a partial sub-wordline driver.

For example, as illustrated in FIG. 10 and FIG. 11A, the odd sub-wordline driver O_SWD0 included in the 0th odd sub-wordline block O_SWB0 disposed at the left edge may drive a single sub-wordline O_SWL0 and may be electrically connected to two column blocks CB0 and CB1. Therefore, the odd sub-wordline driver O_SWD0 included in the 0th odd sub-wordline block O_SWB0 may be a partial sub-wordline driver.

In addition, for example, as illustrated in FIG. 10 and FIG. 11B,the odd sub-wordline driver O_SWD5 included in the 5th odd sub-wordline block 0_SWB5 disposed at the right edge may drive a single sub-wordline O_SWL9 and may be electrically connected to a single column block CB18. Therefore, the odd sub-wordline driver O_SWD5 included in the fifth odd sub-wordline block O_SWB5 may be a partial sub-wordline driver.

The odd sub-wordline block disposed in the middle, among the odd sub-wordline blocks O_SWB0 to O_SWB5, may include a normal sub-wordline driver.

For example, as illustrated in FIG. 10, the odd sub-wordline driver O_SWD1 included in the first odd sub-wordline block O_SWB1 disposed in the middle may drive two sub-wordlines O_SWL1 and O_SWL2 and may be electrically connected to four column blocks CB2, CB3, CB4, and CB5. Therefore, the odd sub-wordline driver O_SWD1 included in the first odd sub-wordline block O_SWB1 may be a normal sub-wordline driver. Similarly, the odd sub-wordline drivers O_SWD2, O_SWD3, and O_SWD4 included in the second to fourth odd sub-wordline blocks O_SWB2 to O_SWB4 may be normal sub-wordline drivers.

Each of the even sub-wordline blocks E_SWB0 to E_SWB4 may include a plurality of even sub-wordline drivers.

For example, the 0th even sub-wordline block E_SWB0 may include a plurality of 0th even sub-wordline drivers E_SWD0. The first even sub-wordline block E_SWB1 may include a plurality of first even sub-wordline drivers E_SWD1. Similarly, the second to fourth even sub-wordline blocks E_SWB2 to E_SWB4 may each include a plurality of even sub-wordline drivers.

The even sub-wordline block disposed at the edge, among the even sub-wordline blocks E_SWB0 to E_SWB4, may include a partial sub-wordline driver.

For example, as illustrated in FIG. 10 and FIG. 11B, the even sub-wordline driver E_SWD4 included in the fourth even sub-wordline block E_SWB4 disposed at the right edge may drive two sub-wordlines E_SWL8 and E_SWL9 and may be electrically connected to three column blocks CB16, CB17, and CB18. Therefore, the even sub-wordline driver E_SWD4 included in the fourth even sub-wordline block E_SWB4 may be a partial sub-wordline driver.

The even sub-wordline block disposed in the middle among the even sub-wordline blocks E_SWB0 to E_SWB4 may include a normal sub-wordline driver.

For example, as illustrated in FIG. 10 and FIG. 11C, the even sub-wordline driver E_SWD1 included in the first even sub-wordline block E_SWB1 disposed in the middle may drive two sub-wordlines E_SWL2 and E_SWL3 and may be electrically connected to four column blocks CB4, CB5, CB6, CB7. Therefore, the even sub-wordline driver E_SWD1 included in the first even sub-wordline block E_SWB1 may be a normal sub-wordline driver. Similarly, the even sub-wordline drivers E_SWD0, E_SWD2, and E_SWD3 included in the 0th, second, and third even sub-wordline blocks E_SWB0, E_SWB2, and E_SWB3 may be normal sub-wordline drivers.

Continuing to refer to FIG. 10, each wordline may include a plurality of sub-wordlines. Each sub-wordline may be driven by a corresponding sub-wordline driver.

For example, a 0th wordline WL0 may include a plurality of odd sub-wordlines O_SWL0 to O_SWL9. Each odd sub-wordline may be driven by a corresponding odd sub-wordline driver. For example, a 0th odd sub-wordline O_SWL0 may be driven by a 0th odd sub-wordline driver O_SWD0. First and second odd sub-wordline O_SWL1 and O_SWL2 may be driven by a first odd sub-wordline driver O_SWD1, third and fourth odd sub-wordline O_SWL3 and O_SWL4 may be driven by a second odd sub-wordline driver O_SWD2, fifth and sixth odd sub-wordline O_SWL5 and O_SWL6 may be driven by a third odd sub-wordline driver O_SWD3, and seventh and eighth odd sub-wordline O_SWL7 and O_SWL8 may be driven by a fourth odd sub-wordline driver O_SWD4. A ninth odd sub-wordline O_SWL9 may be driven by a fifth odd sub-wordline driver O_SWD5.

Similarly, a first wordline WL1 may include a plurality of even sub-wordlines E_SWL0 to E_SWL9, and each even sub-wordline may be driven by a corresponding even sub-wordline driver.

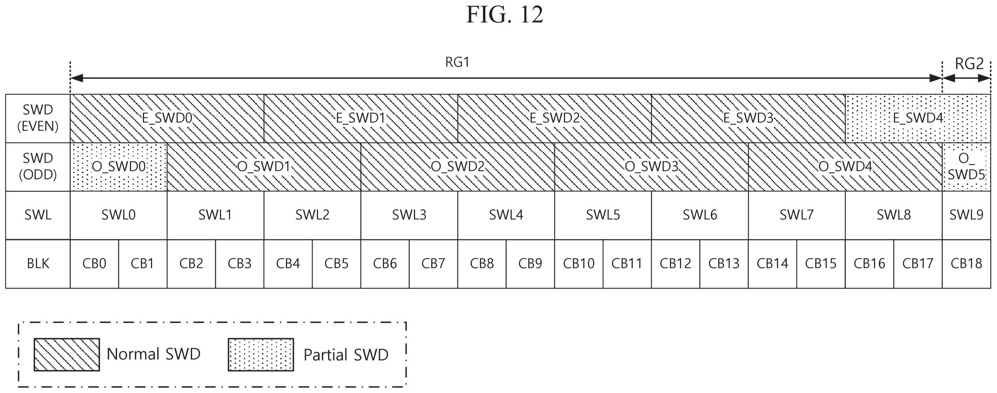

FIG. 12 is a diagram simplifying a layout relationship of the sub-wordline drivers, sub-wordlines, and column blocks described in FIGS. 10 to 11C.

Referring to FIG. 12, according to some implementations, 0th to 4th even sub-wordline drivers E_SWD0 to E_SWD4 may be disposed in a bank array.

The 0th to third even sub-wordline drivers E_SWD0 to E_SWD3 may each be a normal sub-wordline driver, and may correspond to four column blocks.

For example, the 0th even sub-wordline driver E_SWD0 may drive a 0th sub-wordline SWL0 and a first sub-wordline SWL1 and may be electrically connected to the 0th to third column blocks CB0 to CB3. The 0th sub-wordline SWL0 is a sub-wordline corresponding to the 0th and first column blocks CB0 and CB1, and may include a 0th odd sub-wordline O_SWL0 (see FIG. 10) and a 0th even sub-wordline E_SWL0 (see FIG. 10). In addition, the first sub-wordline SWL1 is a sub-wordline corresponding to the second and third column blocks CB2 and CB3, and may include a first odd sub-wordline O_SWL1 (see FIG. 10) and a first even sub-wordline E_SWL1 (see FIG. 10).

The fourth even sub-wordline driver E_SWD4 is a partial sub-wordline driver and may correspond to three column blocks.

For example, the fourth even sub-wordline driver E_SWD4 may drive an eighth sub-wordline SWL8 and a ninth sub-wordline SWL9 and may be electrically connected to the 16th to 18th column blocks CB16 to CB18.

According to some implementations, 0th to fifth odd sub-wordline drivers O_SWD0 to O_SWD5 may be disposed in the bank array.

The first to fourth odd sub-wordline drivers O_SWD1 to O_SWD4 may each be a normal sub-wordline driver and may correspond to four column blocks, respectively.

For example, the first odd sub-wordline driver O_SWD1 may drive a first sub-wordline SWL1 and a second sub-wordline SWL2 and may be electrically connected to the second to fifth column blocks CB2 to CB5.

The 0th and fifth odd sub-wordline drivers O_SWD0 and O_SWD5 are each a partial sub-wordline driver and may correspond to two column blocks and a single column block, respectively.

For example, the 0th odd sub-wordline driver O_SWD0 may drive the 0th sub-wordline SWL0 and may be electrically connected to the 0th and first column blocks CB0 and CB1. The fifth odd sub-wordline driver O_SWD5 may drive the ninth sub-wordline SWL9 and may be electrically connected to the 18th column block CB18.

The first region RG1 may include column blocks connected to the normal sub-wordline drivers. For example, the first region RG1 may include 0th to 17th column blocks CB0 to CB17.

The sub-wordline drivers corresponding to the second to 15th column blocks CB2 to CB15 may all be normal sub-wordline drivers. For example, the second and third column blocks CB2 and CB3 correspond to the 0th even sub-wordline driver E_SWD0 and the first odd sub-wordline driver O_SWD1, and the 0th even sub-wordline driver E_SWD0 and the first odd sub-wordline driver O_SWD1 may both be normal sub-wordline drivers.

In addition, a portion of the sub-wordline drivers corresponding to the 0th, first, 16th, and 17th column blocks CB0, CB1, CB16, and CB17 may be normal sub-wordline drivers, and the remaining portion may be partial sub-wordline drivers. For example, the 0th and first column blocks CB0 and CB1 may correspond to the 0th even sub-wordline driver E_SWD0 and the 0th odd sub-wordline driver O_SWD0. The 0th even sub-wordline driver E_SWD0 may be a normal sub-wordline driver, and the 0th odd sub-wordline driver O_SWD0 may be a partial sub-wordline driver.

The second region RG2 may include column blocks connected to the partial sub-wordline drivers. For example, the second region RG2 may include the 18th column block CB18. The sub-wordline drivers E_SWD4 and O_SWD5 corresponding to the 18th column block CB18 may both be partial sub-wordline drivers.

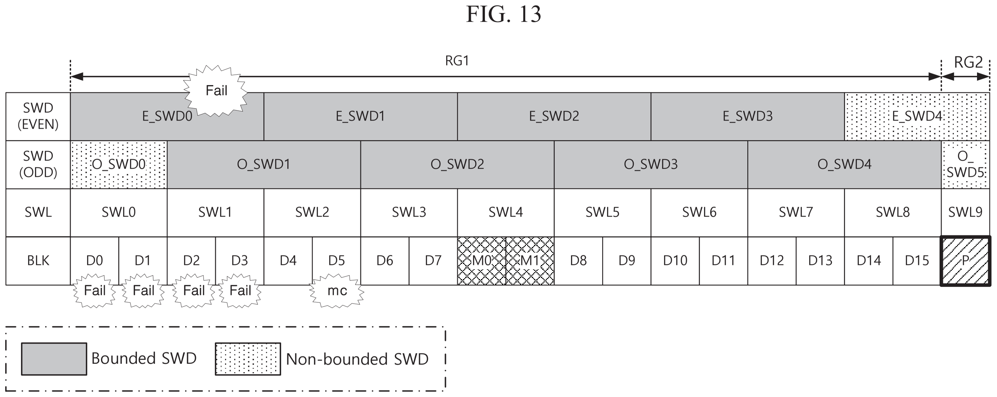

FIG. 13 is a diagram illustrating a comparative example in which a column block corresponding to a partial sub-wordline driver is allocated as a parity block. For ease of description, it is defined that a structure of a bank array of FIG. 13 is the same as the structure of the bank array of FIG. 12. In addition, it is defined that a fault occurs in the 0th even sub-wordline driver E_SWD0.

Referring to FIG. 13, in the comparative example, a column block of the second region RG2 is allocated as the parity block P.

The sub-wordline drivers E_SWD4 and O_SWD5 corresponding to the parity block P are originally all partial sub-wordline drivers. Therefore, regardless of whether the parity block P is allocated, the sub-wordline drivers E_SWD4 and O_SWD5 may be non-bounded sub-wordline drivers. In addition, the 0th odd sub-wordline driver O_SWD0 in the first region RG1 is also a partial sub-wordline driver, and thus may be a non-bounded sub-wordline driver.

In addition, column blocks corresponding to the eight normal sub-wordline drivers E_SWD0 to E_SWD3 and O_SWD1 to O_SWD4 are all allocated as either a data block and/or a meta block. Therefore, the eight normal sub-wordline drivers E_SWD0 to E_SWD3 and O_SWD1 to O_SWD4 may all be bounded sub-wordline drivers.

Under these circumstances, when a fault occurs in one of the bounded sub-wordline drivers, failures may occur in all four column blocks connected thereto. In addition, when a correction error occurs during an ECC operation, the failure may propagate to another column block. For example, when a fault occurs in the 0th even sub-wordline driver E_SWD0, a failure caused by the correction error mc may occur not only in the corresponding data blocks D0 to D3 but also in another data block D5. When the BF condition is limited to a maximum of 4 sub-packets as described above, the BF condition may not be satisfied.

Accordingly, to satisfy the BF condition, the correction error should not propagate to another column block even when a fault occurs in the bounded sub-wordline driver. For example, bounded sub-wordline drivers should be considered when designing an H-matrix. This means that as the number of bounded sub-wordline drivers increases, the design complexity of the H-matrix increases. In the comparative example of FIG. 13, eight bounded sub-wordline drivers should be considered when designing the H-matrix.

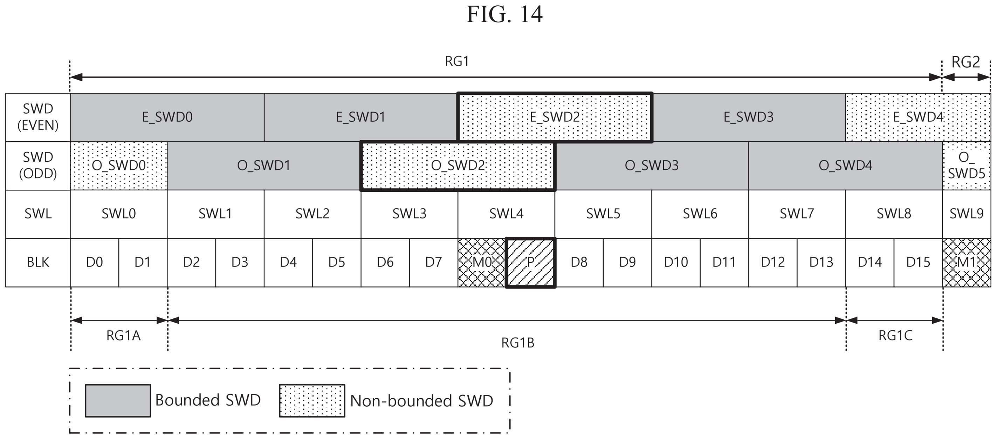

FIG. 14 is a diagram illustrating examples in which a column block corresponding to a normal sub-wordline driver is allocated as a parity block. For ease of description, it is defined that a structure of a bank array of FIG. 14 is the same as the bank array of FIGS. 12 and 13.

Referring to FIG. 14, according to some implementations, one of the column blocks in the first region RG1 may be allocated as a parity block P. For example, the ninth column block in the first region RG1 may be allocated as the parity block P.

The sub-wordline drivers E_SWD2 and O_SWD2 corresponding to the parity block P are all normal sub-wordline drivers. As the parity block P is allocated, the sub-wordline drivers E_SWD2 and O_SWD2 may be classified as non-bounded sub-wordline drivers. Accordingly, the number of bounded sub-wordline drivers may be reduced by 2. For example, while the number of bounded sub-wordline drivers is 8 in the comparative example of FIG. 13, the number of bounded sub-wordline drivers may be 6, which is reduced by 2, in the implementation of FIG. 14. Accordingly, only 6 bounded sub-wordline drivers need to be considered when designing the H-matrix, leading to a reduction in the design complexity of the H-matrix.

Continuing to refer to FIG. 14, the first region RG1 may be classified into three regions RG1A, RG1B, and RG1C. In the 1B region RG1B, each column block may correspond to two normal sub-wordline drivers. Therefore, as illustrated in FIG. 14, when one of the column blocks in the 1B region RG1B is allocated as the parity block P, two normal sub-wordline drivers may be non-bounded. For example, the number of bounded sub-wordline drivers may decrease by 2.

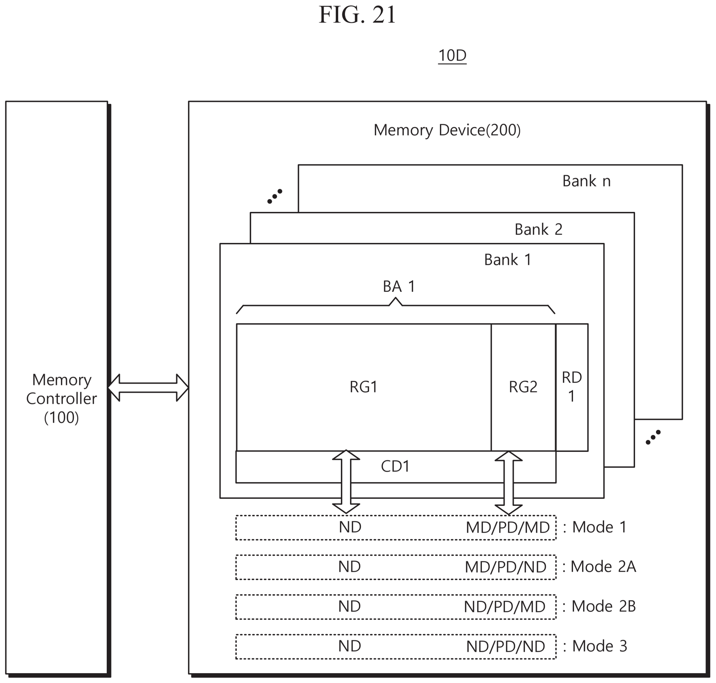

However, this is only an example, and implementations are not limited thereto. According to some implementations, one of the column blocks in the 1A region RG1A or the 1C region RG1C may also be allocated as a parity block. The number of bounded sub-wordline drivers may decrease by 1. This will be described in more detail in FIGS. 21 to 24 below.

FIG. 15 is a diagram illustrating a comparative example in which a column block corresponding to a bounded sub-wordline driver is allocated as a meta block. For ease of description, it is defined that a structure of a bank array of FIG. 15 is the same as those of FIGS. 12 to 14. In addition, it is defined that a tenth column block is allocated as a parity block P, and a fault occurs in a second odd sub-wordline driver O_SWD2. In addition, it is defined that the bank array operates in a third mode Mode 3.

Referring to FIG. 15, in the comparative example, column blocks corresponding to the second odd sub-wordline driver O_SWD2, which is a bounded sub-wordline driver, are allocated as meta blocks M0 and M1.

Under these circumstances, when a fault occurs in the second odd sub-wordline driver O_SWD2, a failure may occur in four column blocks D6, D7, M0, and M1 connected to the second odd sub-wordline driver O_SWD2.

Similarly to the operation of the above-described third mode Mode 3, the column select lines of the 0th meta block M0 may be mapped to the 0th to 7th data blocks D0 to D7, and the column select lines of the first meta block M1 may be mapped to the eighth to 15th data blocks D8 to D15. Accordingly, a combination of data blocks in which the failure has occurred may be (D6, D7, D0 to D7, and D8 to D15). For example, a failure may occur in combinations of data blocks such as (D6, D7, D0, D8), (D6, D7, D1, D8), ..., (D6, D7, D7, D14), and (D6, D7, D7, D15). As a result, when the BF condition is limited to a maximum of 4 sub-packets as described above, the H-matrix should be designed considering many such combinations of data blocks. This means that the design complexity of the H-matrix increases.

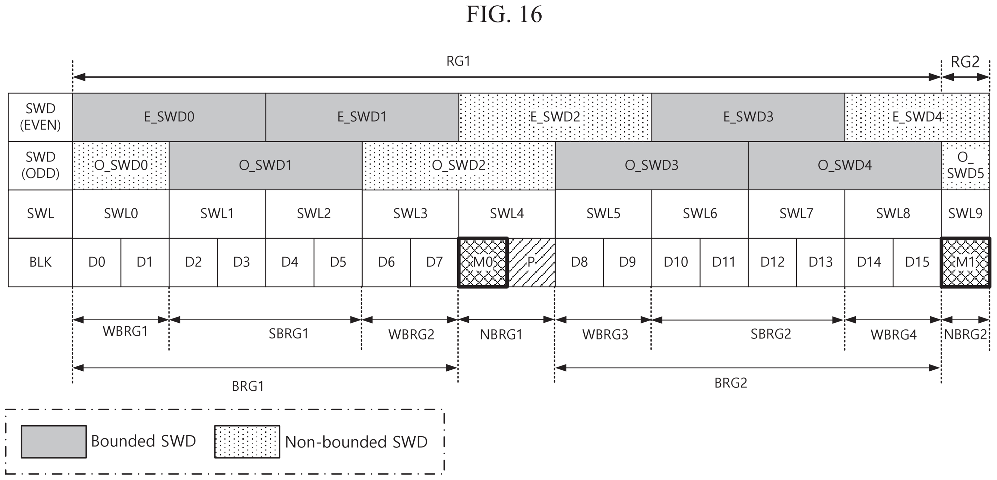

FIG. 16 is a diagram illustrating an example in which a column block corresponding to a non-bounded sub-wordline driver is allocated as a meta block. For ease of description, it is defined that a structure of a bank array of FIG. 16 is the same as those of FIGS. 12 to 15. In addition, similarly to FIG. 14, it is defined that a ninth column block is allocated as a parity block P.

Referring to FIG. 16, a ninth column block in a first region RG1 may be allocated as a parity block P. Therefore, two normal sub-wordline drivers E_SWD2 and O_SWD2 may be non-bounded. The first region RG1 may be classified into a strong bound region SBRG, a weak bound region WBRG, and a non-bound region NBRG based on a bound status of the sub-wordline driver to which each column block corresponds.

For example, 0th and first data blocks D0 and D1 correspond to a single bounded sub-wordline driver E_SWD0. Therefore, the 0th and first data blocks D0 and D1 may belong to a first weak bound region WBRG1.

For example, second to fifth data blocks D2 to D5 correspond to two bounded sub-wordline drivers. For example, the second and third data blocks D2 and D3 correspond to two bounded sub-wordline drivers E_SWD0 and O_SWD1, and the fourth and fifth data blocks D4 and D5 correspond to two bounded sub-wordline drivers O_SWD1 and E_SWD1. Therefore, the second to fifth data blocks D2 to D5 may belong to a first strong bound region SBRG1.

For example, sixth and seventh data blocks D6 and D7 correspond to a single bounded sub-wordline driver E_SWD1. Therefore, the sixth and seventh data blocks D6 and D7 may belong to a second weak bound region WBRG2.

For example, the 0th meta block and the first parity block M0 and P do not correspond to the bounded sub-wordline driver. Therefore, the 0th meta block and the first parity block M0 and P may belong to a first non-bound region NBRG1.

Similarly, eighth and ninth data blocks D8 and D9 may belong to a third weak bound region WBRG3, tenth to thirteenth data blocks D10 to D13 may belong to a second strong bound region SBRG2, and fourteenth and fifteenth data blocks D14 and D15 may belong to a fourth weak bound region WBRG4.

The first meta block M1 in the second region RG2 does not correspond to the bounded sub-wordline driver, and thus may belong to a second non-bound region NBRG2.

Under these circumstances, according to some implementations, the 0th meta block M0 may be allocated to the first non-bound region NBRG1. For example, the 0th meta block M0 may be disposed adjacent to the parity block P. For example, the 0th meta block M0 and the parity block P may correspond to the same sub-wordline driver and the same sub-wordline.

For example, even when a fault occurs in the second odd sub-wordline driver O_SWD2, the combination of column blocks that should be considered for the BF condition may be D6, D7, and M0. For example, only three column blocks should be considered to satisfy the BF condition. When the BF condition is limited to a maximum of 4 sub-packets as described above, the BF condition may be satisfied in spite of occurrence of correction error. Accordingly, when an H-matrix is designed, the combination of data blocks does not need to be considered. Alternatively, when the combination of data blocks is considered, only the combination of D6, D7, and D0 to D7 needs to be considered. As a result, the design complexity of the H-matrix may be reduced.

In addition, according to some implementations, as illustrated in FIG. 16, the first meta block M1 may be allocated to the second non-bound region NBRG2. For example, the first meta block M1 may be allocated to the second region RG2 corresponding to partial sub-wordlines.

For example, even when a fault occurs in the fourth even sub-wordline driver E_SWD4, the combination of column blocks that should be considered for the BF condition may be D14, D15, and M1. Accordingly, when the BF condition is limited to a maximum of 4 sub-packets as described above, the BF condition may be satisfied in spite of occurrence of correction error. Accordingly, when the H-matrix is designed, the combination of data blocks does not need to be considered. Alternatively, when the combination of data blocks is considered, only the combination of D14, D15, and D8 to D15 needs to be considered. As a result, the design complexity of the H-matrix may be reduced.

As a result, the storage device according to some implementations may reduce the design complexity of the H-matrix by arranging the meta blocks M0 and M1 adjacent to the parity block P or by arranging the meta blocks M0 and M1 at the edge of the bank array.

In FIG. 16, both the two meta blocks M0 and M1 have been described as being allocated to the column block of the non-bound region. However, this is only an example, and implementations are not limited thereto. According to some implementations, only one of the two meta blocks M0 and M1 may be disposed in a non-bound region.

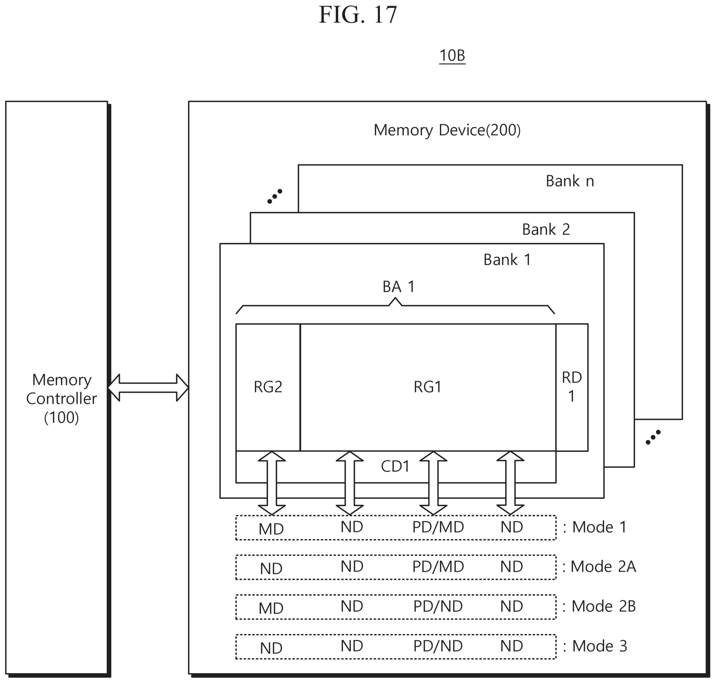

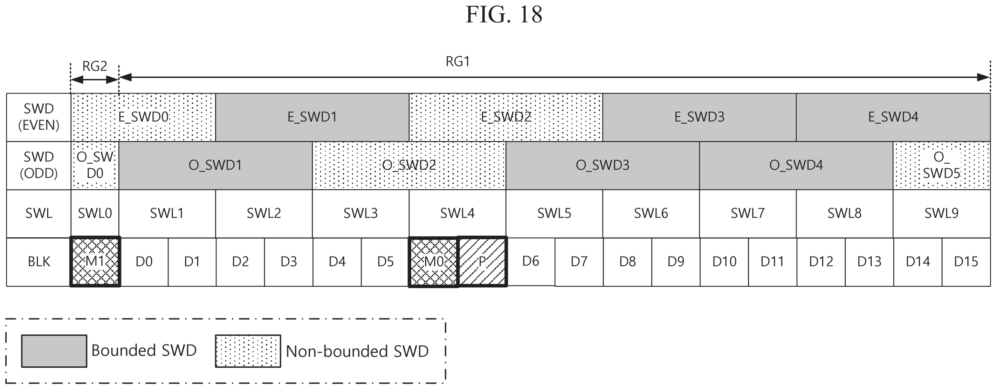

FIG. 17 is a block diagram illustrating a storage device 10B according to some implementations. FIG. 18 is a diagram illustrating an example of a bank array of the storage device of FIG. 17. The storage device and the bank array of FIGS. 17 and 18 are similar to the storage device and the bank array of FIGS. 1 and 14. Therefore, the same or similar configurations are denoted by the same or similar reference numerals, and redundant descriptions thereof will be omitted.

In FIGS. 1 to 18, the second region RG2 has been described as being formed at the right edge of the bank array. For example, in FIGS. 1 to 18, partial sub-wordlines have been described as being disposed at the right edge of the bank array. However, this is merely illustrative, and implementations are not limited thereto.

Referring to FIGS. 17 and 18, the storage device 10B according to some implementations may include a memory controller 100 and a memory device 200. In a bank array of each bank, a second region RG2 may be formed on a left side of the bank array. For example, a 0th even sub-wordline driver E_SWD0 and a 0th odd sub-wordline driver O_SWD0, which are partial sub-wordline drivers, may be disposed at the left side of the bank array.

According to some implementations, the storage device 10B may select one of the plurality of normal sub-wordline drivers in the first region RG1 and allocate at least one of the column blocks corresponding to the selected normal sub-wordline driver as a parity block P. In addition, the 0th meta block M0 may be allocated to correspond to the same sub-wordline driver and the same sub-wordline as the parity block P, and the first meta block M1 may be allocated to correspond to the partial sub-wordline driver.

Accordingly, the storage device 10B may satisfy a BF condition while supporting an ECC operation and/or a meta data mode.

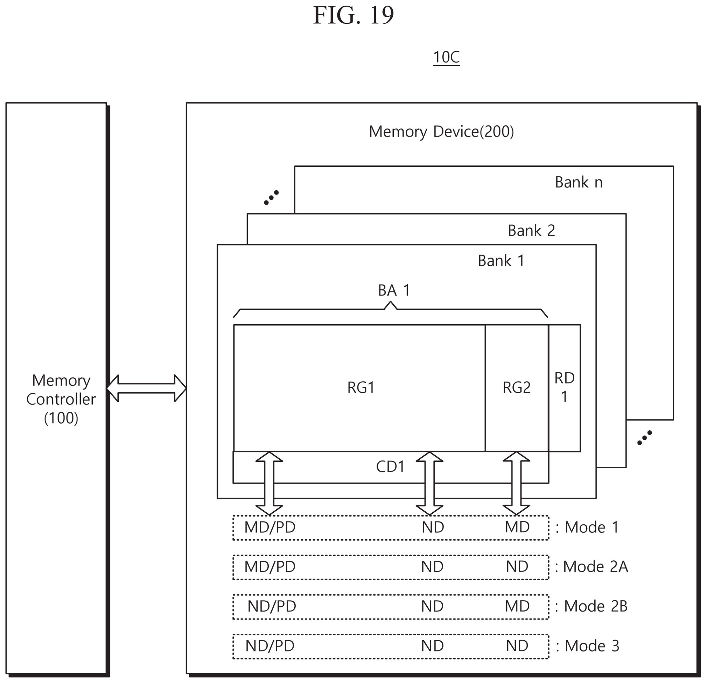

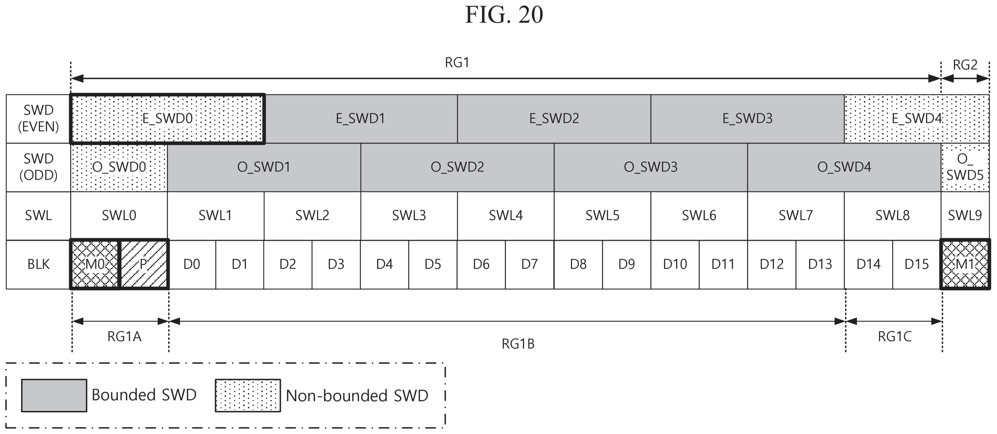

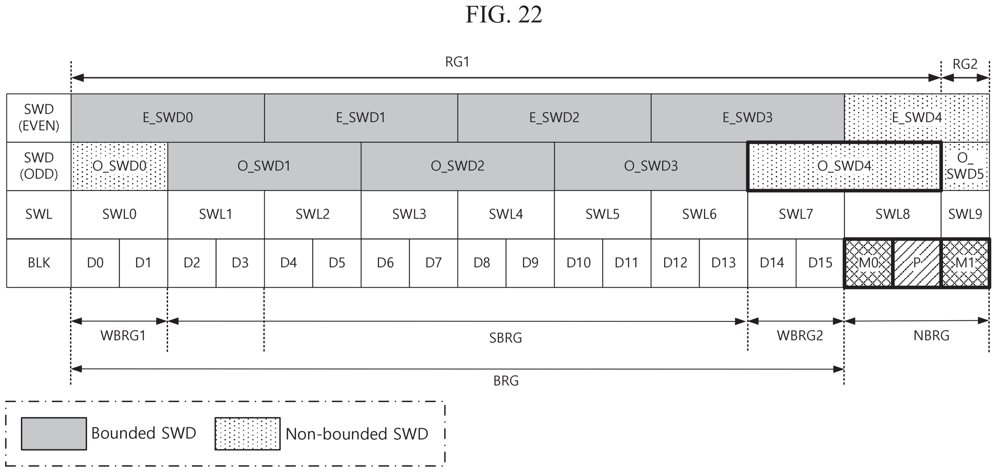

FIG. 19 is a block diagram illustrating a storage device 10C according to some implementations. FIG. 20 is a diagram illustrating an example of a bank array of the storage device of FIG. 19. FIG. 21 is a block diagram illustrating a storage device 10D according to some implementations. FIG. 22 is a diagram illustrating an example of a bank array of the storage device of FIG. 21. The storage device and the bank array of FIGS. 19 to 22 are similar to the storage device and the bank array of FIGS. 1 and 14. Therefore, the same or similar configurations are denoted by the same or similar reference numerals, and redundant descriptions will be omitted.

In FIGS. 1 and 14, the first region RG1 has been described as being divided into three regions RG1A, RG1B, and RG1C, and one of the column blocks in the first B region RG1B has been described as being allocated as the parity block P. However, this is merely illustrative, and implementations are not limited thereto.

Referring to FIGS. 19 and 20, the storage device 10C may allocate one of the column blocks in the first A region RG1A as a parity block P.

Column blocks in the first A region RG1A may each correspond to a single normal sub-wordline driver and a single partial sub-wordline driver. Accordingly, when one of the column blocks in the first A region RG1A is allocated as the parity block P, a single normal sub-wordline driver may be non-bounded. For example, the number of bounded sub-wordline drivers may decrease by 1. Accordingly, the design complexity of an H-matrix may be reduced compared to the comparative example of FIG. 13.

Alternatively, referring to FIGS. 21 and 22, a storage device 10D according to some implementations may allocate one of the column blocks in a first C region RG1C as a parity block P.

Column blocks in the first C region RG1C may each correspond to a single normal sub-wordline driver and a single partial sub-wordline driver. Accordingly, when one of the column blocks in the first C region RG1C is allocated as a parity block P, a single normal sub-wordline driver may be non-bounded. For example, the number of bounded sub-wordline drivers may decrease by 1. Accordingly, the design complexity of an H-matrix may be reduced compared to the comparative example of FIG. 13.

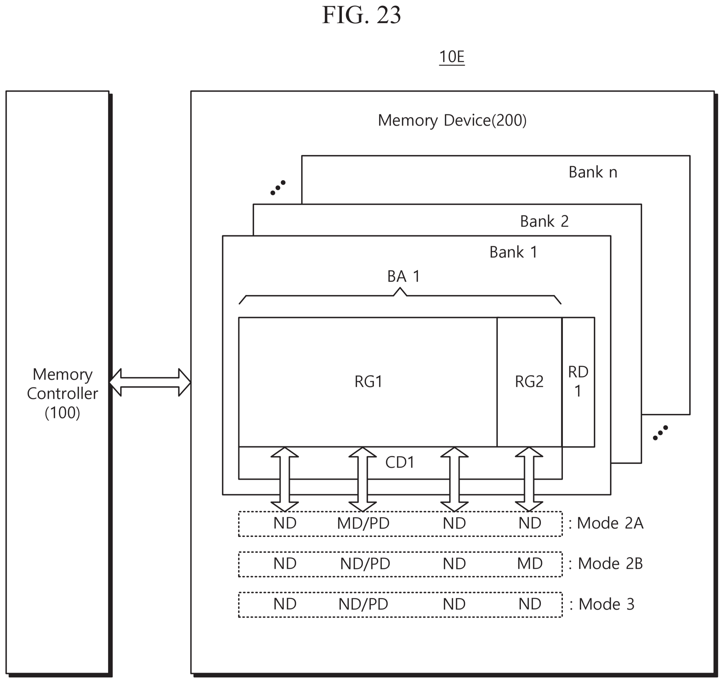

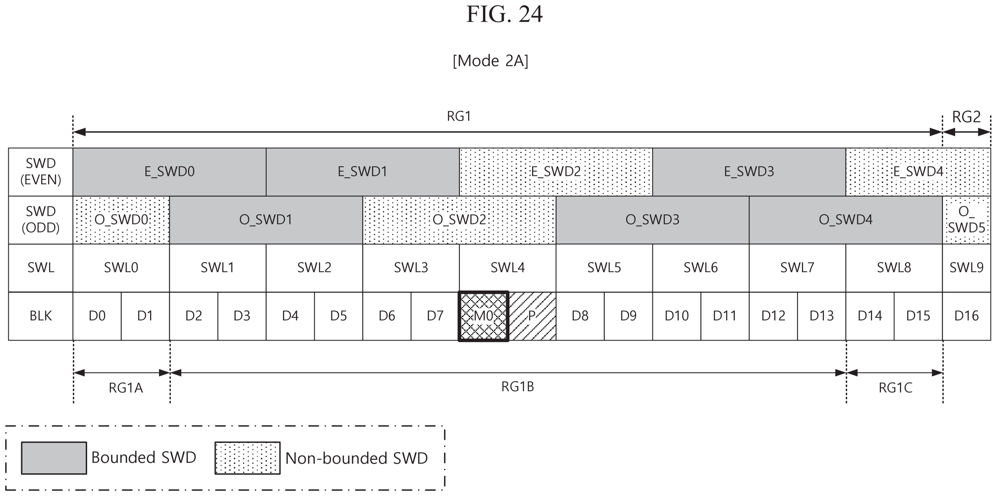

FIG. 23 is a block diagram illustrating a storage device 10E according to some implementations, and FIG. 24 is a diagram illustrating an example of a bank array of the storage device of FIG. 23. The storage device and the bank array of FIGS. 23 and 24 are similar to the storage device and the bank array of FIGS. 1 to 18. Therefore, the same or similar configurations are denoted by the same or similar reference numerals, and redundant descriptions thereof will be omitted.

In FIGS. 1 to 18, two meta blocks have been described as being provided. However, this is merely illustrative, and implementations are not limited thereto. According to some implementations, only one meta block may be provided, or no meta block may be provided.

Referring to FIGS. 23 and 24, the storage device 10E according to some implementations may provide only one meta block M0. For example, as illustrated in FIG. 24, the meta block M0 may be allocated to a column block adjacent to the parity block P allocated to a first B region RG1B. An operation corresponding to the above-mentioned Mode 2A may be performed. Alternatively, the meta block M0 may be allocated to a column block of the second region RG2, and an operation corresponding to the above-mentioned Mode 2B may be performed.

As a result, the storage device 10E according to some implementations may provide only one meta block, and may support the meta data mode excluding the first mode Mode 1 of FIG. 1A.

As set forth above, according to some implementations, a memory device may satisfy a bounded fault condition while supporting an error correction operation and/or a meta data mode.

While various implementations have been shown and described above, it will be apparent to those skilled in the art that modifications and variations could be made without departing from the scope of the present inventive concept as defined by the appended claims.

## Claims

1. A memory device comprising:
a bank array (BA1 to BAn) comprising a plurality of memory cells (MC);
a row decoder (260_1 to 260_n) connected to the bank array (BA1 to BAn) through a plurality of wordlines (WL0 to WLi); and
a column decoder (270_1 to 270_n) connected to the bank array (BA1 to BAn) through a plurality of column select lines (CSLO to CSLI),
wherein the bank array (BA1 to BAn) comprises:
a first region (RG1) comprising a plurality of normal sub-wordline drivers (SWD1 to SWD3); and
a second region (RG2) comprising at least one partial sub-wordline driver (SWD4); and
wherein a column block of a plurality of column blocks (CB, CB0 to CBj) is allocated as a parity block, the plurality of column blocks (CB, CB0 to CBj) corresponding to the plurality of normal sub-wordline drivers (SWD1 to SWD3) in the first region (RG1).

2. The memory device of claim 1, wherein:
the plurality of normal sub-wordline drivers (SWD1 to SWD3) in the first region (RG1) comprise:
a first normal sub-wordline driver (SWD1) adjacent to a side of the bank array (BA1 to BAn);
a second normal sub-wordline driver (SWD3) adjacent to the second region (RG2); and
a third normal sub-wordline driver (SWD2) between the first normal sub-wordline driver (SWD1) and the second normal sub-wordline driver (SWD2); and
a column block, among column blocks connected to the third normal sub-wordline driver (SWD2), is allocated as the parity block.

3. The memory device of claim 1 or 2, wherein:
a column block corresponding to the at least one partial sub-wordline driver (SWD4) in the second region (RG2) is allocated as a meta block.

4. The memory device of any one of claims 1 to 3, wherein:
a column block adjacent to the parity block, among the plurality of column blocks in the first region (RG1), is allocated as a meta block.

5. The memory device of claim 4, wherein:
the parity block and the meta block correspond to a same sub-wordline of a same normal sub-wordline driver of the plurality of normal sub-wordline drivers (SWD1 to SWD3) in the first region (RG1).

6. The memory device of any one of claims 1 to 5, wherein:
a first column block adjacent to the parity block, among the plurality of column blocks (CB, CB0 to CBj) in the first region (RG1), is allocated as a first meta block; and
a second column block corresponding to the at least one partial sub-wordline driver (SWD4) in the second region (RG2) is allocated as a second meta block.

7. The memory device of claim 1, wherein:
the plurality of normal sub-wordline drivers (SWD1 to SWD3) in the first region (RG1) comprises:
a first normal sub-wordline driver adjacent to a side of the bank array;
a second normal sub-wordline driver adjacent to the second region (RG2); and
a third normal sub-wordline driver between a first normal sub-wordline driver and a second normal sub-wordline driver of the plurality of normal sub-wordline drivers (SWD1 to SWD3); and
a first column block, among column blocks connected to the first normal sub-wordline driver, is allocated as the parity block.

8. The memory device of claim 7, wherein:
a second column block adjacent to the first column block, among the column blocks connected to the first normal sub-wordline driver, is allocated as a first meta block; and
a third column block corresponding to the at least one partial sub-wordline driver in the second region (RG2) is allocated as a second meta block.

9. The memory device of claim 1, wherein:
the plurality of normal sub-wordline drivers (SWD1 to SWD3) in the first region (RG1) comprise:
a first normal sub-wordline driver adjacent to a side of the bank array;
a second normal sub-wordline driver adjacent to the second region (RG2); and
a third normal sub-wordline driver between the first normal sub-wordline driver and the second normal sub-wordline driver; and
a first column block, among column blocks connected to the second normal sub-wordline driver, is allocated as the parity block.

10. The memory device of claim 9, wherein:
a second column block adjacent to the first column block, among column blocks connected to the second normal sub-wordline driver in the first region (RG1), is allocated as a first meta block; and
a third column block corresponding to the at least one partial sub-wordline driver in the second region (RG2) is allocated as a second meta block.

11. The memory device of claim 10, wherein:
the parity block, the first meta block, and the second meta block are adjacent to one another.

12. The memory device of any one of claims 1 to 11, wherein:
a first normal sub-wordline driver to which the parity block is allocated, among the plurality of normal sub-wordline drivers (SWD1 to SWD3) in the first region (RG1), is configured to operate as a non-bounded sub-wordline driver;
a second normal sub-wordline driver, among the plurality of normal sub-wordline drivers (SWD1 to SWD3) in the first region (RG1), outside an allocation of the parity block, is configured to operate as a bounded sub-wordline driver; and
based on a correction error occurring in the bounded sub-wordline driver, a region in which the correction error has occurred is confined to column blocks corresponding to the bounded sub-wordline driver.

13. The memory device of claim 12, wherein:
the at least one partial sub-wordline driver (SWD4) in the second region (RG2) is configured to operate as the non-bounded sub-wordline driver.

14. The memory device of any one of claims 1 to 13, wherein:
data output from the first region (RG1) and data output from the second region (RG2) are simultaneously output through a single read operation.

15. The memory device of any one of claims 1 to 14, wherein:
a first column block of a plurality of column blocks corresponding to the plurality of normal sub-wordline drivers (SWD1 to SWD3) in the first region (RG1) is allocated as a data block;
a second column block corresponding to the at least one partial sub-wordline driver in the second region (RG2) is allocated as a meta block; and
a number of column select lines of the data block is less than a number of column select lines of the meta block.
